# EUROPEAN PATENT APPLICATION

(11) **EP 4 346 033 A1**
(43) Date of publication of application: **03.04.2024**
(21) Application number: 23168458.0
(22) Date of filing: 18.04.2023
(51) Int. Cl.: H01S 5/02, H01S 5/026, H01S 5/42, H01S 5/042, H01S 5/02345, H01S 5/323, H01S 5/30, H01S 5/062, H01S 5/183

(54) **LIGHT-EMITTING COMPONENT, MULTILAYER SEMICONDUCTOR SUBSTRATE, LIGHT-EMITTING DEVICE, AND MEASUREMENT APPARATUS**

(30) Priority: 27.09.2022 JP 2022154166
(71) Applicant: FUJIFILM Business Innovation Corp., Minato-ku Tokyo (JP); FUJIFILM Corporation, Tokyo 106-8620 (JP)
(72) Inventor: NISHIZAKI, Saori, Ebina-shi (JP); KONDO, Takashi, Ebina-shi (JP); HIGUCHI, Takafumi, Ebina-shi (JP)
(74) Representative: Haseltine Lake Kempner LLP

(57) **Abstract**

A light-emitting component includes: a substrate; multiple light-emitting elements provided on the substrate, each having a light-emitting area; and multiple thyristors which are provided on each of the light-emitting elements, which include gate layers, and which cause light to be emitted, or increase an amount of light emitted, from the light-emitting areas of the light-emitting elements by being in an ON state. The substrate absorbs light emitted from the thyristors and emits light not absorbed by the gate layers.

## Description

### Background

### (i) Technical Field

The present disclosure relates to a light-emitting component, a multilayer semiconductor substrate, a light-emitting device, and a measurement apparatus.

### (ii) Related Art

Japanese Unexamined Patent Application Publication No. 2018-6502 discloses a light-emitting component provided with a substrate, multiple light-emitting elements formed from vertical-cavity surface-emitting lasers provided on the substrate, and a setting thyristor which is layered on and used to drive each of the light-emitting elements. In this light-emitting component, when the setting thyristor is turned on, a current flows between the setting thyristor and the light-emitting element, causing the light-emitting element to emit light.

### Summary

Incidentally, a thyristor that is turned on may emit light in some cases. In a light-emitting component or the like provided with multiple thyristors, if light emitted from one thyristor that has been turned on propagates to another thyristor, the other thyristor may turn on in response to the propagated light. In this case, a light-emitting element not intended to emit light may emit light due to the other thyristor that has been turned on, making it difficult to control light emission by the light-emitting element. Accordingly, it is an object of the present disclosure to keep a thyristor from being switched to the ON state by light emitted from another thyristor compared to a case in which a substrate provided with light-emitting elements and multiple thyristors does not absorb light emitted from the thyristors.

According to a first aspect of the present disclosure, there is provided a light-emitting component including: a substrate; multiple light-emitting elements provided on the substrate, each having a light-emitting area; and multiple thyristors which are provided on each of the light-emitting elements, which include gate layers, and which cause light to be emitted, or increase an amount of light emitted, from the light-emitting areas of the light-emitting elements by being in an ON state, wherein the substrate absorbs light emitted from the thyristors and emits light not absorbed by the gate layers.

According to a second aspect of the present disclosure, in the light-emitting component according to the first aspect, the light-emitting elements transmit light emitted from the thyristors.

According to a third aspect of the present disclosure, in the light-emitting component according to the second aspect, the light-emitting elements have a semiconductor layer containing Al, and the gate layers of the thyristors contain Al and are formed from a semiconductor with a low Al content ratio compared to the semiconductor layer of the light-emitting elements.

According to a fourth aspect of the present disclosure, in the light-emitting component according to the third aspect, the semiconductor layer of the light-emitting elements is a multilayer reflective layer in which a first semiconductor layer formed from AlGaAs and a second semiconductor layer formed from AlGaAs with a high Al content ratio compared to the first semiconductor layer are layered alternately, and the gate layers of the thyristors are formed from AlGaAs with a low Al content ratio compared to the first semiconductor layer of the multilayer reflective layer.

According to a fifth aspect of the present disclosure, in the light-emitting component according to the second aspect, the light-emitting elements have a lower semiconductor layer layered on the substrate, a light-emitting layer layered on the lower semiconductor layer, and an upper semiconductor layer layered on the light-emitting layer, the upper semiconductor layer having a high transmittance of light emitted from the thyristors compared to the lower semiconductor layer.

According to a sixth aspect of the present disclosure, in the light-emitting component according to any of the first to fifth aspects, the substrate emits, toward the light-emitting elements, light of a longer wavelength than the light emitted from the thyristors.

According to a seventh aspect of the present disclosure, in the light-emitting component according to the sixth aspect, the gate layers of the thyristors are formed from a semiconductor containing Al, and the substrate is formed from GaAs.

According to an eighth aspect of the present disclosure, there is provided a multilayer semiconductor substrate including: a substrate; a first semiconductor stack which is provided on the substrate and which is worked into a light-emitting element; and a second semiconductor stack which is provided on the first semiconductor stack, which includes gate layers, and which is worked into a plurality of thyristors, wherein the substrate is formed from a semiconductor with a low band gap energy compared to the gate layers of the second semiconductor stack.

According to a ninth aspect of the present disclosure, there is provided a light-emitting device including: a substrate; multiple light-emitting elements provided on the substrate, each having a light-emitting area; and multiple thyristors which are provided on each of the light-emitting elements, which include gate layers, and which cause light to be emitted, or increase an amount of light emitted, from the light-emitting areas of the light-emitting elements by being in an ON state; and a driving unit that individually drives and causes the multiple thyristors to switch to an ON state, wherein the substrate absorbs light emitted from the thyristors and emits light not absorbed by the gate layers.

According to a 10th aspect of the present disclosure, there is provided a measurement apparatus including: a substrate; multiple light-emitting elements provided on the substrate, each having a light-emitting area; multiple thyristors which are provided on each of the light-emitting elements, which include gate layers, and which cause light to be emitted, or increase an amount of light emitted, from the light-emitting areas of the light-emitting elements by being in an ON state; a driving unit that individually drives the plurality of thyristors and causes each of the light-emitting areas to emit light at a predetermined timing; and an acquisition unit that acquires information related to an object on a basis of reflected light obtained due to the object reflecting the light from each of the light-emitting areas, wherein the substrate absorbs light emitted from the thyristors and emits light not absorbed by the gate layers.

According to an 11th aspect of the present disclosure, in the light-emitting component according to the second aspect, the gate layers of the thyristors are formed from a semiconductor with a low band gap energy compared to a semiconductor layer of the light-emitting elements.

According to a 12th aspect of the present disclosure, in the light-emitting component according to the 11th aspect, the semiconductor layer of the light-emitting elements is a multilayer reflective layer in which a first semiconductor layer and a second semiconductor layer with a high band gap energy compared to the first semiconductor layer are layered alternately, and the gate layers of the thyristors are formed from a material with a low band gap energy compared to the first semiconductor layer of the multilayer reflective layer.

According to a 13th aspect of the present disclosure, in the light-emitting component according to the second aspect, the light-emitting elements have a semiconductor layer containing Al, and the gate layers of the thyristors are formed from a semiconductor not containing Al.

According to the light-emitting component according to the first aspect, it is possible to keep a thyristor from being switched to the ON state by light emitted from another thyristor compared to a case in which a substrate provided with light-emitting elements and multiple thyristors does not absorb light emitted from the thyristors.

According to the light-emitting component according to the second aspect, it is possible to suppress a temperature rise in a light-emitting element compared to a case in which the light-emitting element does not transmit light emitted from a thyristor.

According to the light-emitting component according to the third aspect, light emitted from a thyristor is absorbed less easily by a light-emitting element compared to a case in which the gate layers of the thyristor have a higher Al content ratio than the semiconductor layer of the light-emitting element.

According to the light-emitting component according to the fourth aspect, light emitted from a thyristor is absorbed less easily by a light-emitting element compared to a case in which the gate layers of the thyristor are formed from AlGaAs having a higher Al content ratio than a first semiconductor layer.

According to the light-emitting component according to the fifth aspect, a degradation in the characteristics of a light-emitting element due to a temperature rise is suppressed compared to a case in which an upper semiconductor layer has a low transmittance of light emitted from a thyristor compared to a lower semiconductor layer.

According to the light-emitting component according to the sixth aspect, light emitted from a substrate is absorbed less easily by a thyristor compared to a case in which the substrate emits light on the same wavelength as light emitted from the thyristor.

According to the light-emitting component according to the seventh aspect, light emitted from a substrate is absorbed less easily by a thyristor compared to case in which the substrate contains Al.

According to the multilayer semiconductor substrate according to the eighth aspect, it is possible to keep a thyristor from being switched to the ON state by light emitted from another thyristor compared to a case in which a substrate provided with light-emitting elements and multiple thyristors does not absorb light emitted from the thyristors.

According to the light-emitting device according to the ninth aspect, it is possible to keep a thyristor from being switched to the ON state by light emitted from another thyristor compared to a case in which a substrate provided with light-emitting elements and multiple thyristors does not absorb light emitted from the thyristors.

According to the measurement apparatus according to the 10th aspect, it is possible to keep a thyristor from being switched to the ON state by light emitted from another thyristor compared to a case in which a substrate provided with light-emitting elements and multiple thyristors does not absorb light emitted from the thyristors.

According to the light-emitting component according to the 11th aspect, light emitted from a thyristor is absorbed less easily by a light-emitting element.

According to the light-emitting component according to the 12th aspect, light emitted from a thyristor is absorbed less easily by a light-emitting element.

According to the light-emitting component according to the 13th aspect, light emitted from a thyristor is absorbed less easily by a light-emitting element.

### Brief Description of the Drawings

An exemplary embodiment of the present disclosure will be described in detail based on the following figures, wherein:
Fig. 1 is a diagram illustrating an example of a measurement apparatus to which an exemplary embodiment is applied;
Fig. 2 is a diagram for describing a light source device to which the exemplary embodiment is applied;
Figs. 3A and 3B are examples of a plan layout and a cross section, respectively, of a light-emitting chip to which the exemplary embodiment is applied;
Fig. 4 is an example of an enlarged cross section of islands in which a VCSEL and a setting thyristor are layered;
Fig. 5 is a timing chart for describing an example of operations by the light source device and the light-emitting chip;
Fig. 6 is a diagram for describing an example of the behavior of light emitted from the setting thyristor when the substrate does not absorb the light emitted from the setting thyristor; and
Fig. 7 is a diagram for describing an example of the behavior of light emitted from the setting thyristor in the light-emitting chip to which the exemplary embodiment is applied.

### Detailed Description

Hereinafter, an exemplary embodiment of the present disclosure will be described in detail and with reference to the attached drawings. The following describes a case in which a light source device 1 including a light-emitting chip 10 as one example of a light-emitting component is applied to, for example, a measurement apparatus that measures the three-dimensional shape (hereinafter referred to as the 3D shape) of an object of measurement.

### (Measurement apparatus 100)

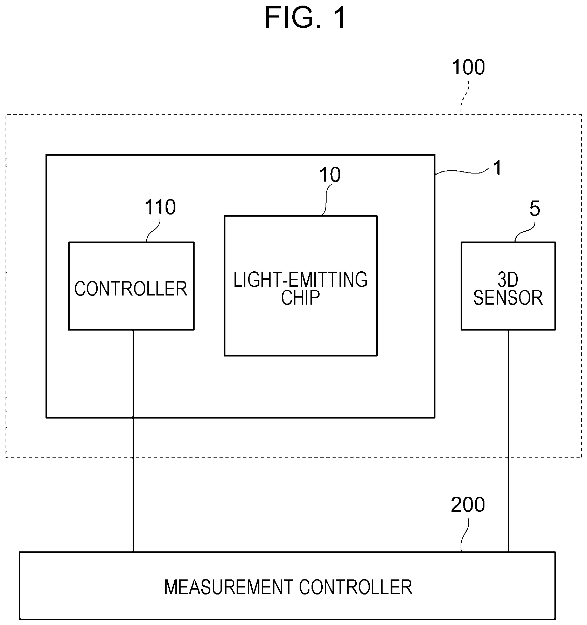

Fig. 1 is a diagram illustrating an example of a measurement apparatus 100 to which the exemplary embodiment is applied. The measurement apparatus 100 of the exemplary embodiment measures the three-dimensional shape (hereinafter referred to as the 3D shape) of an object of measurement. The measurement apparatus 100 measures the 3D shape on the basis of the time of flight of light, also referred to as the ToF method. The measurement apparatus 100 is provided with: a light source device 1 as one example of a light-emitting device including a light-emitting chip 10 and a controller 110; and a three-dimensional sensor (hereinafter referred to as the 3D sensor) 5. In the ToF method, time is measured from the timing when light is emitted from the light source device 1 to the timing when the 3D sensor 5 receives light reflected by the object of measurement. The distance to the object of measurement is then calculated from the time acquired from the 3D sensor 5, and the 3D shape of the object of measurement is specified. The action of measuring the 3D shape may also be referred to as three-dimensional measurement, 3D measurement, or 3D sensing.

The light source device 1 emits light toward the object of measurement. The 3D sensor 5 acquires light (reflected light) that is reflected back by the object of measurement. The 3D sensor 5 outputs information (distance information) on the distance to the object of measurement based on the time, measured using the ToF method, between when light is emitted and when reflected light is received. Note that the measurement apparatus 100 may also include a measurement controller 200. The measurement controller 200 is configured as a computer including a CPU, ROM, RAM, and the like, and specifies the 3D shape of the object of measurement on the basis of the distance information acquired from the 3D sensor 5.

The measurement apparatus 100 may also be applied to the recognition of the object of measurement from the specified 3D shape. For example, the measurement apparatus 100 is mounted to a mobile information processing device and used to recognize the face of a user attempting to access the device. In other words, the 3D shape of the accessing user's face is acquired to determine whether or not access is permitted, and the use of the device itself (the mobile information processing device) is permitted only if the user is recognized as an authorized user. Furthermore, the measurement apparatus 100 is also applicable to the case of ongoing measurement of the 3D shape of the object of measurement, such as with augmented reality (AR) and the like.

### (Light source device)

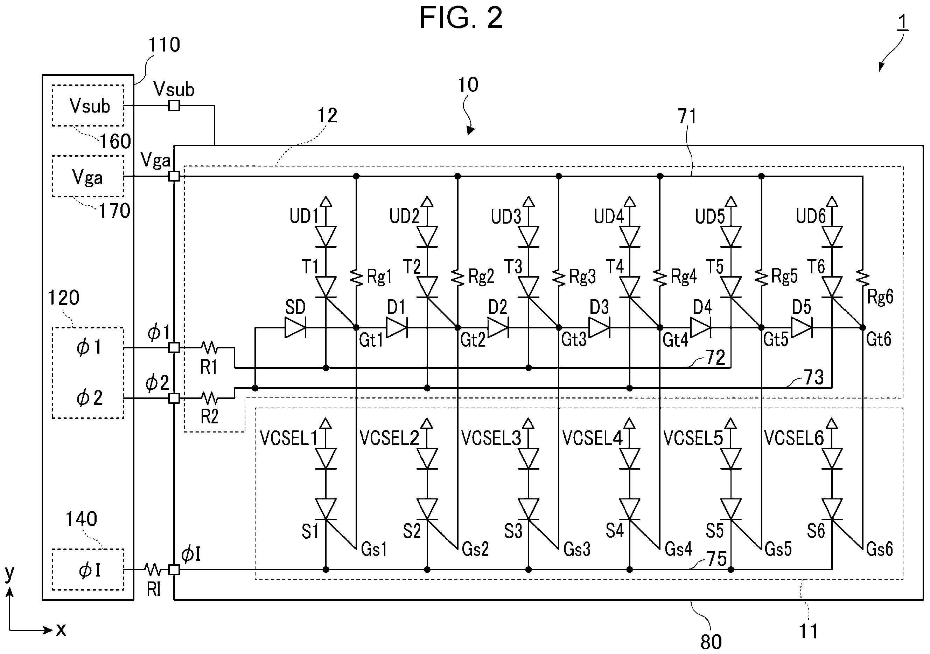

Fig. 2 is a diagram for describing the light source device 1 to which the exemplary embodiment is applied. In Fig. 2, the rightward direction of the page is defined as the +x direction. Note that in the light source device 1 illustrated in Fig. 2, the positions of terminals (ϕ1 terminal, ϕ2 terminal, Vga terminal, ϕI terminal) are not necessarily accurate. The light source device 1 illustrated in Fig. 2 is provided with the light-emitting chip 10 and the controller 110.

### (Controller 110)

The controller 110 is provided with a transfer signal generation unit 120, a lighting signal generation unit 140, a reference potential supply unit 160, and a power supply potential supply unit 170. The transfer signal generation unit 120 generates transfer signals ϕ1 and ϕ2 that sequentially transfer the ON state to multiple transfer thyristors T described later. The lighting signal generation unit 140 generates a lighting signal ϕI that supplies a current for lighting up (inducing emission) in multiple vertical-cavity surface-emitting lasers (VCSELs) described later. The reference potential supply unit 160 supplies a reference potential Vsub. The power supply potential supply unit 170 supplies a power supply potential Vga.

### (Light-emitting chip 10)

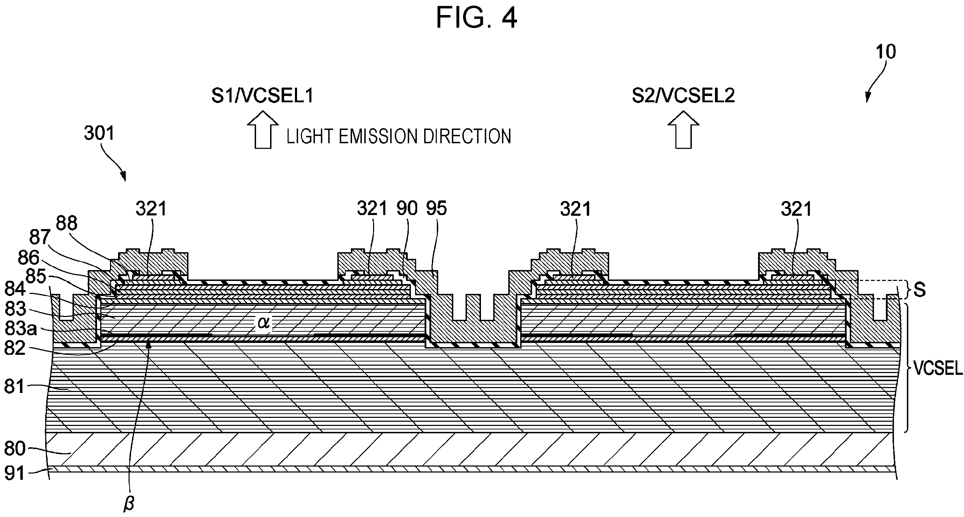

The light-emitting chip 10 is provided with a light-emitting unit 11 and a transfer unit 12. The light-emitting chip 10 is also provided with a ϕ1 terminal, a ϕ2 terminal, a Vga terminal, a ϕI terminal, and a Vsub terminal. The light-emitting unit 11 is provided with vertical-cavity surface-emitting lasers (VCSELs). In the following the vertical-cavity surface-emitting lasers are referred to as the VCSELs. In the example illustrated in Fig. 2, six VCSELs from VCSEL1 to VCSEL6 (referred to as the VCSEL(s) when not being distinguished individually) are provided. The light-emitting unit 11 is also provided with six setting thyristors S1 to S6 (referred to as the setting thyristor(s) S when not being distinguished individually). The anode of the VCSEL and the cathode of the setting thyristor S are connected. In other words, the VCSEL and the setting thyristor S of the same numeral are connected in series. Moreover, as illustrated in Fig. 4 described later, the setting thyristor S is layered on the VCSEL formed on a substrate 80. Note that in the following, the setting thyristor S may be referred to as the thyristor in some cases. In the exemplary embodiment, each VCSEL is an example of a light-emitting element. Also, each setting thyristor S is an example of a thyristor.

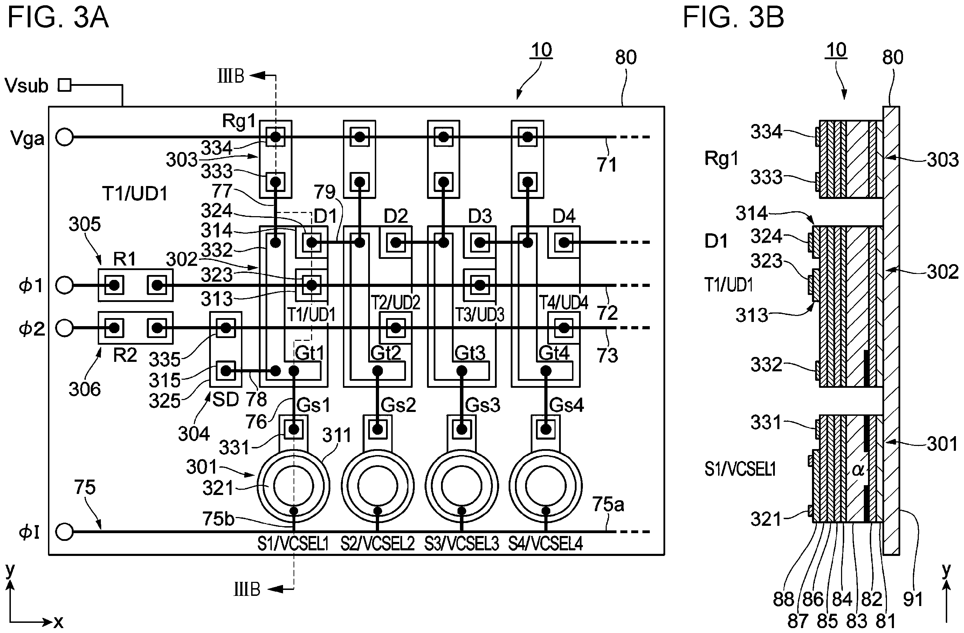

The transfer unit 12 is provided with six transfer thyristors T1 to T6 (referred to as the transfer thyristor(s) T when not being distinguished individually) and six lower diodes UD1 to UD6 (referred to as the lower diode(s) UD when not being distinguished individually). Also, among the transfer thyristors T1 to T6 and the lower diodes UD1 to UD6, the transfer thyristor T and the lower diode UD of the same numeral are connected in series. Moreover, as illustrated in Fig. 3B described later, the transfer thyristor T is layered on the lower diode UD formed on the substrate 80.

The transfer unit 12 is also provided with coupling diodes D1 to D5 (hereinafter referred to as the coupling diode(s) D when not being distinguished individually) each coupling the pair of each two of the transfer thyristors T1 to T6 in numerical order. Furthermore, the transfer unit 12 is provided with power supply line resistors Rg1 to Rg6 (referred to as the power supply line resistor(s) Rg when not being distinguished individually).

The transfer unit 12 is also provided with a single start diode SD. The transfer unit 12 is also provided with current-limiting resistors R1 and R2, which are provided to keep an excessive current from flowing on a first transfer signal line 72 supplied with a first transfer signal cp 1 and a second transfer signal line 73 supplied with a second transfer signal ϕ2 described later.

The VCSEL1 to VCSEL6 and the setting thyristors S1 to S6 of the light-emitting unit 11 and the transfer thyristors T1 to T6, the lower diodes UD1 to UD6, the coupling diodes D1 to D5, and the power supply line resistors Rg1 to Rg6 of the transfer unit 12 are arranged in numerical order from one side (-x side, the left side in Fig. 2) to the other side (+x side, the right side in Fig. 2) of the light-emitting chip 10.

In the exemplary embodiment, there are six of each of the VCSELs and the setting thyristors S in the light-emitting unit 11 and the transfer thyristors T, the lower diodes UD, and the power supply line resistors Rg in the transfer unit 12. Note that there are five coupling diodes D, that is, one less than the number of transfer thyristors T. The numbers of the VCSELs, setting thyristors S, transfer thyristors T, lower diodes UD, power supply line resistors Rg, and coupling diodes D are not limited to the above and may simply be predetermined numbers. Also, the number of transfer thyristors T may be greater than the number of VCSELs.

Each of the VCSEL, lower diode UD, coupling diode D, and start diode SD above is a two-terminal semiconductor element with an anode terminal (anode) and a cathode terminal (cathode). Each thyristor (setting thyristor S, transfer thyristor T) is a three-terminal semiconductor element with an anode terminal (anode), a gate terminal (gate), and a cathode terminal (cathode). Note that in the following, the terminals may be referenced by the terms in parentheses and "terminal" may be omitted in some cases.

In the light-emitting chip 10 of the exemplary embodiment, the VCSELs, setting thyristors S, lower diodes UD, transfer thyristors T, coupling diodes D, power supply line resistors Rg, and start diode SD are configured as an integrated circuit by a semiconductor stack formed by epitaxial growth on a common semiconductor substrate (hereinafter referred to as the substrate 80). The semiconductor stack is formed using a III-V compound semiconductor such as GaAs, AlGaAs, or AlAs, for example.

Next, the electrical connections of each element in the light-emitting chip 10 will be described. The anode of each of the VCSEL and the lower diode UD is connected to the substrate 80 (anode common). These anodes are supplied with a reference potential Vsub through a back electrode 91, which is a Vsub terminal provided on the back of the substrate 80. The cathode of each VCSEL is connected to the anode of the setting thyristor S. Also, the cathode of each lower diode UD is connected to the anode of the transfer thyristor T. Note that this connection is a configuration for the case of using a p-type substrate 80, and in the case of using an n-type substrate, the polarity is reversed. In the case of using an intrinsic (i) substrate that is not doped with impurities, the terminal that supplies the reference potential Vsub is provided on the side of the substrate where the light-emitting unit 11 and the transfer unit 12 are provided.

The cathodes of the odd-numbered transfer thyristors T1, T3, and T5 along the array of the transfer thyristors T are connected to the first transfer signal line 72. Additionally, the first transfer signal line 72 is connected to the ϕ1 terminal through the current-limiting resistor R1. The cp 1 terminal is supplied with the first transfer signal cp 1 from the transfer signal generation unit 120 of the controller 110. On the other hand, the cathodes of the even-numbered transfer thyristors T2, T4, and T6 along the array of the transfer thyristors T are connected to the second transfer signal line 73. Additionally, the second transfer signal line 73 is connected to the ϕ2 terminal through the current-limiting resistor R2. The ϕ2 terminal is supplied with the second transfer signal ϕ2 from the transfer signal generation unit 120 of the controller 110.

The cathode of each setting thyristor S is connected to a lighting signal line 75. The lighting signal line 75 is connected to the ϕI terminal. In the light-emitting chip 10, the ϕI terminal is supplied with a lighting signal ϕI from the lighting signal generation unit 140 of the controller 110 via a current-limiting resistor RI provided outside the light-emitting chip 10. The lighting signal ϕI supplies a current for lighting the VCSELs.

The gates Gt1 to Gt6 (hereinafter referred to as the gate(s) Gt when not being distinguished individually) of each of the transfer thyristors T1 to T6 are connected in a 1:1 manner to the gates Gs1 to Gs6 (hereinafter referred to as the gate(s) Gs when not being distinguished individually) of the setting thyristors S1 to S6 of the same numeral. Therefore, the gates Gt1 to Gt6 and the gates Gs1 to Gs6 of the same numeral have the same electrical potential. For this reason, these gates will be referred to as the gate Gt1 (gate Gs1), for example, to indicate that the potential is the same.

The coupling diodes D1 to D5 are each connected between the pair of each two of the gates Gt1 to Gt6 of each of the transfer thyristors T1 to T6 in numerical order. That is, each of the coupling diodes D1 to D5 is connected directly to be interposed between each of the gates Gt1 to Gt6. Additionally, the coupling diode D1 is connected in the direction such that a current flows from the gate Gt1 to the gate Gt2. The same applies to the other coupling diodes D2 to D5.

The gate Gt (gate Gs) of the transfer thyristor T is connected to a power supply line 71 through the power supply line resistor Rg provided in correspondence with each transfer thyristor T. The power supply line 71 is connected to the Vga terminal. The Vga terminal is supplied with a power supply potential Vga from the power supply potential supply unit 170 of the controller 110.

Additionally, the gate Gt1 of the transfer thyristor T1 is connected to the cathode of the start diode SD. On the other hand, the anode of the start diode SD is connected to the second transfer signal line 73.

Figs. 3A and 3B are examples of a plan layout and a cross section, respectively, of the light-emitting chip 10 to which the exemplary embodiment is applied. Fig. 3A is an example of a plan layout of the light-emitting chip 10, and Fig. 3B is an example of a cross section taken along the line IIIB-IIIB in Fig. 3A. Note that in Figs. 3A and 3B, a protective layer (protective layer 90 in Fig. 4 described later) and a light-blocking layer (light-blocking layer 95 in Fig. 4 described later) to be described later are omitted. Also, each connection wiring illustrated in Fig. 3A is omitted from Fig. 3B.

First, the cross-sectional structure of the light-emitting chip 10 will be described using Fig. 3B. In the light-emitting chip 10, a p-type anode layer 81 including the VCSEL and the lower diode UD, a light-emitting layer 82, and an n-type cathode layer 83 are provided in the above order on a p-type substrate 80 (substrate 80). Although details are described later, in the light-emitting chip 10 of the exemplary embodiment, the p-type anode layer 81 and the n-type cathode layer 83 are formed from distributed Bragg reflector (DBR) layers (hereinafter referred to as DBR layers) in which multiple semiconductor layers with refractive index differences are layered. Consequently, in the following the p-type anode layer 81 is referred to as the p anode (DBR) layer 81. Similarly, the n-type cathode layer 83 is referred to as the n cathode (DBR) layer 83.

In the light-emitting chip 10, a tunnel junction (tunnel diode) layer 84 (tunnel junction layer 84) is also provided on the n cathode (DBR) layer 83. Additionally, in the light-emitting chip 10, a p-type anode layer 85 (p anode layer 85), an n-type gate layer 86 (n gate layer 86), a p-type gate layer 87 (p gate layer 87), and an n-type cathode layer 88 (n cathode layer 88) forming the setting thyristor S, the transfer thyristor T, the coupling diode D, and the power supply line resistor Rg are provided in the above order on the tunnel junction layer 84. Note that in the following, the terms in parentheses will be used. The same applies elsewhere.

Elements such as the VCSEL, the lower diode UD, the setting thyristor S, the transfer thyristor T, and the coupling diode D are formed from multiple islands that are isolated by partially removing each of the above layers by etching. Note that the islands are referred to as mesas in some cases, and the etching for forming the islands (mesas) is referred to as mesa etching in some cases. Additionally, in the light-emitting chip 10, these islands are connected to wiring such as the power supply line 71, the first transfer signal line 72, the second transfer signal line 73, and the lighting signal line 75 through through-holes (denoted by O in Fig. 3A) provided in the protective layer (protective layer 90 in Fig. 4 described later). In the following, the protective layer and the through holes are omitted from the description.

Also, as illustrated in Fig. 3B, a back electrode 91 on the back of the substrate 80 that serves as the Vsub terminal is provided on the back of the substrate 80.

Herein, the designations of the p anode (DBR) layer 81 and the n cathode (DBR) layer 83 correspond to the functions (actions) when the VCSEL and the lower diode UD are configured. That is, the p anode (DBR) layer 81 functions as the anode while the n cathode (DBR) layer 83 functions as the cathode. Likewise, the designations of the p anode layer 85, the n gate layer 86, the p gate layer 87, and the n cathode layer 88 correspond to the functions (actions) when the setting thyristor S and the transfer thyristor T are configured. That is, the p anode layer 85 functions as the anode, the n gate layer 86 and the p gate layer 87 function as the gate, and the n cathode layer 88 functions as the cathode. Note that when the coupling diode D and the power supply line resistor Rg are configured, each of the above layers has a different function, as described later.

Note that, as described below, the multiple islands of the light-emitting chip 10 include islands not provided with a portion the layers among the p anode (DBR) layer 81, the light-emitting layer 82, the n cathode (DBR) layer 83, the tunnel junction layer 84, the p anode layer 85, the n gate layer 86, the p gate layer 87, and the n cathode layer 88. For example, islands 301 and 302 described later are not provided with a portion of the n cathode layer 88.

Next, an example of the plan layout of the light-emitting chip 10 will be described using Fig. 3A. The VCSEL1 and the setting thyristor S1 are provided in an island 301. The lower diode UD1, the transfer thyristor T1, and the coupling diode D1 are provided in an island 302. The power supply line resistor Rg1 is provided in an island 303. The start diode SD is provided in an island 304. The current-limiting resistor R1 is provided in an island 305, and the current-limiting resistor R2 is provided in an island 306. Additionally, in the light-emitting chip 10, islands similar to the islands 301, 302, and 303 are formed multiply in parallel. In these islands, the VCSEL2 to VCSEL6, the setting thyristors S2 to S6, the lower diodes UD2 to UD6, the transfer thyristors T2 to T6, the coupling diodes D2 to D5, and the like are provided similarly as in the islands 301, 302, and 303.

The islands 301 to 306 will be described in detail using Figs. 3A and 3B. As illustrated in Fig. 3B, the VCSEL1 provided in the island 301 is formed from the p anode (DBR) layer 81, the light-emitting layer 82, and the n cathode (DBR) layer 83. The setting thyristor S is formed from the p anode layer 85, the n gate layer 86, the p gate layer 87, and the n cathode layer 88 layered through the tunnel junction layer 84 which is layered on the n cathode (DBR) layer 83 of the VCSEL1.

As indicated by the blackening in Fig. 3B, the n cathode (DBR) layer 83 of the VCSEL includes a current constriction layer (current constriction layer 83a in Fig. 4 described later) that constricts the current. The current constriction layer is a current blocking section β where a portion of the semiconductor layer forming the n cathode (DBR) layer exposed by mesa etching is oxidized from the periphery, thereby making it difficult for a current to flow. On the other hand, the central, non-oxidized portion of the semiconductor layer forming the n cathode (DBR) layer is a current passing section α where a current flows easily. As illustrated in the VCSEL1 in Fig. 3A, the portion on the inside of the dashed line is the current passing section α and the portion on the outside of the dashed line is the current blocking section β. Note that the current blocking section β is not required to block the flow of a current completely, and the current may simply be concentrated in the current passing section α. That is, a current may simply flow less easily in the current blocking section β compared to the current passing section α. By providing the current blocking section β, the power consumed for non-luminescent recombination is lowered. By providing the current blocking section β, low power consumption and improved light extraction efficiency are attained. Note that light extraction efficiency refers to the amount of light extracted per unit of power.

In the setting thyristor S1, an n-type ohmic electrode 321 (n ohmic electrode 321) provided on an area 311 of the n cathode layer 88 serves as a cathode terminal. Also, a p type ohmic electrode 331 (p ohmic electrode 331) provided on the p gate layer 87 exposed by removing the n cathode layer 88 serves as the terminal of the gate Gs1.

The lower diode UD1 provided in the island 302 is formed from the p anode (DBR) layer 81, the light-emitting layer 82, and the n cathode (DBR) layer 83, similarly to the VCSEL. The transfer thyristor T1 is formed from the p anode layer 85, the n gate layer 86, the p gate layer 87, and the n cathode layer 88 layered through the tunnel junction layer 84 which is layered on the n cathode (DBR) layer 83 of the lower diode UD1, similarly to the setting thyristor S1. An n ohmic electrode 323 provided on an area 313 of the n cathode layer 88 serves as a cathode terminal. Also, a p ohmic electrode 332 provided on the p gate layer 87 exposed by removing the n cathode layer 88 serves as the terminal of the gate Gt1. Likewise, the coupling diode D1 provided in the island 302 is formed from the p gate layer 87 and the n cathode layer 88. An n ohmic electrode 324 provided on an area 314 of the n cathode layer 88 serves as a cathode terminal. Also, the p ohmic electrode 332 provided on the p gate layer 87 exposed by removing the n cathode layer 88 serves as an anode terminal. Here, the anode terminal of the coupling diode D1 is the same as the gate Gt1.

The power supply line resistor Rg1 provided in the island 303 is formed from the p gate layer 87. That is, in the power supply line resistor Rg1, the p gate layer 87 is provided as resistance between a p ohmic electrode 333 and a p ohmic electrode 334 provided on the p gate layer 87 exposed by removing the n cathode layer 88.

The start diode SD provided in the island 304 is formed from the p gate layer 87 and the n cathode layer 88. That is, an n ohmic electrode 325 provided on an area 315 of the n cathode layer 88 serves as a cathode terminal. Also, a p ohmic electrode 335 provided on the p gate layer 87 exposed by removing the n cathode layer 88 serves as an anode terminal. The current-limiting resistor R1 provided in the island 305 and the current-limiting resistor R2 provided in the island 306 are provided in a similar manner as the power supply line resistor Rg1 provided in the island 303, with each having the p gate layer 87 serving as resistance between two p ohmic electrodes (no reference sign).

Next, the connection relationships between the elements in Fig. 3A will be described. The lighting signal line 75 is provided with a trunk 75a and a branch 75b. The trunk 75a is provided extending in the arrangement direction of the setting thyristors S/VCSELs. The branch 75b branches off from the trunk 75a and is connected to the n ohmic electrode 321, that is, the cathode terminal of the setting thyristor S1 provided in the island 301. The same applies to the cathode terminals of the other setting thyristors S. The lighting signal line 75 is connected to the ϕI terminal provided on the setting thyristor S1/VCSEL1 side.

The first transfer signal line 72 is connected to the n ohmic electrode 323, that is, the cathode terminal of the transfer thyristor T1 provided in the island 302. The cathode terminals of the other odd-numbered transfer thyristors T, which are provided in islands similar to the island 302, are connected to the first transfer signal line 72. The first transfer signal line 72 is connected to the ϕ1 terminal through the current-limiting resistor R1 provided in the island 305. On the other hand, the second transfer signal line 73 is connected to n ohmic electrodes (no reference sign) that are the cathode terminals of the even-numbered transfer thyristors T provided in islands not given reference signs. The second transfer signal line 73 is connected to the ϕ2 terminal through the current-limiting resistor R2 provided in the island 306.

The power supply line 71 is connected to the p ohmic electrode 334, that is, one terminal of the power supply line resistor Rg1 provided in the island 303. The power supply line 71 is also connected to one terminal of the other power supply line resistors Rg. The power supply line 71 is connected to the Vga terminal.

The p ohmic electrode 331 (gate terminal Gs1) of the setting thyristor S1 provided in the island 301 is connected to the p ohmic electrode 332 (gate terminal Gt1) in the island 302 by connection wiring 76.

The p ohmic electrode 332 (gate terminal Gt1) is connected to the p ohmic electrode 333 (the other terminal of the power supply line resistor Rg1) in the island 303 by connection wiring 77. The n ohmic electrode 324 (the cathode terminal of the coupling diode D1) provided in the island 302 is connected to a p-type ohmic electrode (no reference sign) which is the gate terminal Gt2 of the adjacent transfer thyristor T2 by connection wiring 79. Although omitted from description here, the same applies to the other VCSELs, setting thyristors S, transfer thyristors T, coupling diodes D, and the like.

The p ohmic electrode 332 (gate terminal Gt1) in the island 302 is connected to the n ohmic electrode 325 (the cathode terminal of the start diode SD) provided in the island 304 by connection wiring 78. The p ohmic electrode 335 (the anode terminal of the start diode SD) is connected to the second transfer signal line 73. Note that the above connections and configuration are for the case of using a p-type substrate 80; in the case of using an n-type substrate, the polarity is reversed. In the case of using an i-type substrate, the terminal that supplies the reference potential Vsub is provided on the side of the substrate where the light-emitting unit 11 and the transfer unit 12 are provided. Also, the above connections and configuration are similar to the case of using either a p-type substrate or an n-type substrate.

### (Layered structure of VCSEL and setting thyristor S)

Fig. 4 is an example of an enlarged cross section of islands in which the VCSEL and the setting thyristor S are layered. Note that Fig. 4 corresponds a cross-sectional view, from the -y direction, of islands in which the VCSEL and the setting thyristor S are layered. Also, Fig. 4 illustrates the island 301 in which the VCSEL1 and the setting thyristor S1 are layered and an island (no reference sign) in which the VCSEL2 and the setting thyristor S2 are layered. In Fig. 4, the VCSEL 1 and VCSEL2 are referred to as the VCSEL without distinction. Similarly, the setting thyristor S1 and setting thyristor S2 are referred to as the setting thyristor S without distinction. As described above, the setting thyristor S is layered on the VCSEL through the tunnel junction layer 84. That is, the VCSEL and the setting thyristor S are connected in series. Note that "on the VCSEL" does not refer only to the state of being in direct contact with the VCSEL, and also includes the state of being positioned above and not in direct contact. The same applies to similar expressions such as "on the substrate".

As illustrated in Fig. 4, the VCSEL is formed from a semiconductor stack of the p anode (DBR) layer 81, the light-emitting layer 82, the n cathode (DBR) layer 83 formed by epitaxial growth in the above order on the p-type substrate 80. The p anode (DBR) layer 81 and the n cathode (DBR) layer 83 are DBR layers in which multiple high refractive index layers with a relatively high refractive index and multiple low refractive index layers with a relatively low refractive index are layered alternately. The p anode (DBR) layer 81 and the n cathode (DBR) layer 83 are configured to reflect light emitted by the VCSEL. Note that the p anode (DBR) layer 81 and the n cathode (DBR) layer 83 will be described in detail at a later stage.

The n cathode (DBR) layer 83 is configured to include the current narrowing layer 83a. In this example, the current narrowing layer 83a is provided on the side of the n cathode (DBR) layer 83 that faces the light-emitting layer 82. The current narrowing layer 83a contains the current passing section α and the current blocking section β. As illustrated in Fig. 4, the current passing section α is provided in the central part of the VCSEL while the current blocking section β is provided at the periphery of the VCSEL. In other words, the portion of the current narrowing layer 83a is the current blocking section β, whereas the portion not provided with the current narrowing layer 83a is the current passing section α. Note that the current narrowing layer may also be provided in the p anode (DBR) layer 81.

The light-emitting layer 82 is a quantum well structure in which a well layer and a barrier layer are layered alternately. Note that the light-emitting layer 82 may also be an intrinsic (i) type layer (i layer) not doped with impurities. The light-emitting layer 82 may also have a structure other than a quantum well, such as a quantum wire structure or a quantum dot structure, for example.

The tunnel junction layer 84 is the junction of an n⁺⁺ layer doped with a high concentration of n-type impurities (dopants) and a p⁺⁺ layer doped with a high concentration of p-type impurities, through which a current flows due to the tunneling effect even with a reverse bias. The tunnel junction layer 84 suppresses reverse biasing of the n cathode (DBR) layer 83 of the VCSEL and the setting thyristor S, which makes it difficult for a current to flow. A current flows due to the tunneling effect even with a reverse bias.

The setting thyristor S is formed from the p anode layer 85, the n gate layer 86, the p gate layer 87, and the n cathode layer 88 which are layered on the tunnel junction layer 84. In other words, there is a four-layer, pnpn structure.

These semiconductor layers are layered by metalorganic chemical vapor deposition (MOCVD) or molecular beam epitaxy (MBE), for example, to form the semiconductor stack. Note that the configuration of the substrate 80, the configuration of the p anode (DBR) layer 81, the light-emitting layer 82, and the n cathode (DBR) layer 83 forming the VCSEL, and the configuration of the p anode layer 85, the n gate layer 86, the p gate layer 87, and the n cathode layer 88 forming the setting thyristor S will be described in detail at a later stage.

The n ohmic electrode 321 is, for example, Ge-containing Au (AuGe), which easily makes ohmic contact with an n-type semiconductor layer such as the n cathode layer 88. The p ohmic electrode 331 (see Fig. 3B) is, for example, Zn-containing Au (AuZn), which easily makes ohmic contact with a p-type semiconductor layer such as the p gate layer 87. The back electrode 91 is, for example, AuZn, similarly to the p ohmic electrode 331.

Note that in the above, the p ohmic electrode 331 is provided on the p gate layer 87 to serve as the gate Gs of the setting thyristor S, but an n ohmic electrode may also be provided on the n gate layer 86 to serve as the gate Gs of the setting thyristor S.

The light-emitting chip 10 is also provided with the protective layer 90 formed from a translucent insulating material provided to cover the surfaces and sides of the islands. The protective layer 90 is formed from SiO₂, SiON, or SiN, for example. Additionally, the light-emitting chip 10 is provided with the light-blocking layer 95 to keep light emitted from the setting thyristor S or the like from leaking out to the surface of the light-emitting chip 10 from between the islands. The light-blocking layer 95 may also be the wiring described above.

### (Relationship between adjacent setting thyristors S and adjacent VCSELs)

As described, in the light-emitting chip 10 of the exemplary embodiment, the semiconductor layers layered on the substrate 80 are partially removed in the thickness direction by mesa etching to form each of the islands. For example, in the island (island 301) where the VCSEL and the setting thyristor S are layered, among the semiconductor layers layered on the substrate 80, the n cathode layer 88, the p gate layer 87, the n gate layer 86, the p anode layer 85, the tunnel junction layer 84, the n cathode (DBR) layer 83, and the light-emitting layer 82 are removed from the top, and a portion of the p anode (DBR) layer 81 is also removed. With this arrangement, each setting thyristor S is formed from the p anode layer 85, the n gate layer 86, the p gate layer 87, and the n cathode layer 88 divided from the adjacent setting thyristor S. In other words, the p anode layer 85, the n gate layer 86, the p gate layer 87, and the n cathode layer 88 forming each setting thyristor S are not continuous with the adjacent setting thyristor S.

On the other hand, in the VCSEL of the exemplary embodiment, the semiconductor layer forming the VCSEL (for example, the VCSEL1) corresponding to one setting thyristor S (for example, the setting thyristor S1) among the multiple setting thyristors S and the semiconductor layer forming the VCSEL (for example, the VCSEL2) corresponding to another adjacent setting thyristor S (for example, the setting thyristor S2) are at least partially continuous. Note that the semiconductor layer forming the VCSEL corresponding to one setting thyristor S is an example of a first area, and the semiconductor layer forming the VCSEL corresponding to another setting thyristor S is an example of a second area. Specifically, in the VCSEL of the exemplary embodiment, a portion of the lowermost p anode (DBR) layer 81 is continuous between adjacent VCSELs. Note that in the VCSEL, the light-emitting layer 82 and n cathode (DBR) layer 83 which are layered on the p anode (DBR) layer 81 are not continuous with the adjacent VCSEL. Furthermore, the VCSEL of the exemplary embodiment includes the p anode (DBR) layer 81 as one example of a lower semiconductor layer that is layered on the substrate 80 and continuous throughout the adjacent VCSEL1 and VCSEL2. The VCSEL of the exemplary embodiment further includes the n cathode (DBR) layer 83 as one example of an upper semiconductor layer divided between the adjacent VCSEL1 and VCSEL2.

### (Thyristors)

Next, the basic operations of the thyristors (transfer thyristor T and setting thyristor S) will be described. As described above, the thyristor is a semiconductor element with the three terminals of an anode terminal (anode), a cathode terminal (cathode), and a gate terminal (gate), and is formed by, for example, layering p-type semiconductor layers (p anode layer 85, p gate layer 87) and n-type semiconductor layers (n gate layer 86, n cathode layer 88) containing GaAs, AlGaAs, AlAs, or the like on the substrate 80. That is, the thyristor has a pnpn structure. Herein, an example will be described in which the pn junction formed between the p-type semiconductor layers and the n-type semiconductor layers has a forward potential (diffusion potential) Vd of 1.5 V.

As an example, the following description describes a case in which the reference potential Vsub supplied to the Vsub terminal, that is, the back electrode 91 (see Figs. 3B and 4) is treated as a high-level potential (hereinafter referred to as "H") of 0 V, and the power supply potential Vga supplied to the Vga terminal is treated as a low-level potential (hereinafter referred to as "L") of -5 V. Therefore, the above may be referred to as "H" (0 V) and "L" (-5 V).

First, the operations of a single thyristor will be described. The anode of the thyristor is assumed to be 0 V. When a potential lower than a threshold voltage (a negative potential having a large absolute value) is applied to the cathode of the thyristor in the OFF state with no current flowing between the anode and the cathode, the thyristor is switched to the ON state (turns on). Here, the threshold voltage of the thyristor is the value obtained by subtracting the forward potential Vd (1.5 V) of the pn junction from the gate potential. When switched to the ON state, the gate of the thyristor goes to a potential close to the potential of the anode terminal. Here, since the anode is 0 V, the gate goes to 0 V. Also, the cathode of the thyristor in the ON state goes to a potential close to the potential obtained by subtracting the forward potential Vd (1.5 V) of the pn junction from the anode potential. Here, since the anode is 0 V, the cathode of the thyristor in the ON state goes to a potential close to -1.5 V (a negative potential having an absolute value larger than 1.5 V). Note that the cathode potential is set by the relationship with the power supply that supplies a current to the thyristor in the ON state.

When the cathode of the thyristor in the ON state goes to a higher potential (a negative potential having a small absolute value, a potential of 0 V, or a positive potential) than the potential sufficient to maintain the ON state (the above potential close to -1.5 V), the thyristor is switched to the OFF state (turns off). On the other hand, if a lower potential (a negative potential having a large absolute value) than the potential sufficient to maintain the ON state is continually supplied to the cathode of the thyristor in the ON state and a current (maintenance current) sufficient to maintain the ON state is supplied, the thyristor remains in the ON state.

Next, the operations with the VCSEL and the setting thyristor S in the layered state will be described. The setting thyristor S is layered on the VCSEL and connected in series. Therefore, the potential of the lighting signal ϕI is divided between the VCSEL and the setting thyristor S. In this description, the voltage applied to the VCSEL is assumed to be -1.7 V. When the setting thyristor S is in the OFF state, -3.3 V is applied to the setting thyristor S. As described above, if the threshold voltage of the setting thyristor S in the OFF state has an absolute value greater than -3.3 V, the voltage applied to the cathode of the setting thyristor S is lower than the threshold voltage, and thus the setting thyristor S turns on. Thereafter, a current flows through the VCSEL and the setting thyristor S connected in series, and the VCSEL emits light. On the other hand, if the threshold voltage of the setting thyristor S has an absolute value less than -3.3 V, the setting thyristor S remains in the OFF state without turning on. Note that if the setting thyristor S turns on, the absolute value of the voltage applied to the VCSEL and the setting thyristor S connected in series is lowered by the current-limiting resistor RI (see Fig. 2). However, if the voltage applied to the setting thyristor S is a voltage that maintains the ON state of the setting thyristor S, the setting thyristor S remains in the ON state. With this arrangement, the VCSEL also continues to emit light.

Note that the voltages indicated above are merely examples and are changed depending on the light emission wavelength and light intensity of the VCSEL. In such cases, the potential ("L") of the lighting signal ϕI may simply be adjusted.

### (Operations of light source device 1)

Next, the operations of the light source device 1 will be described.

### <Timing chart>

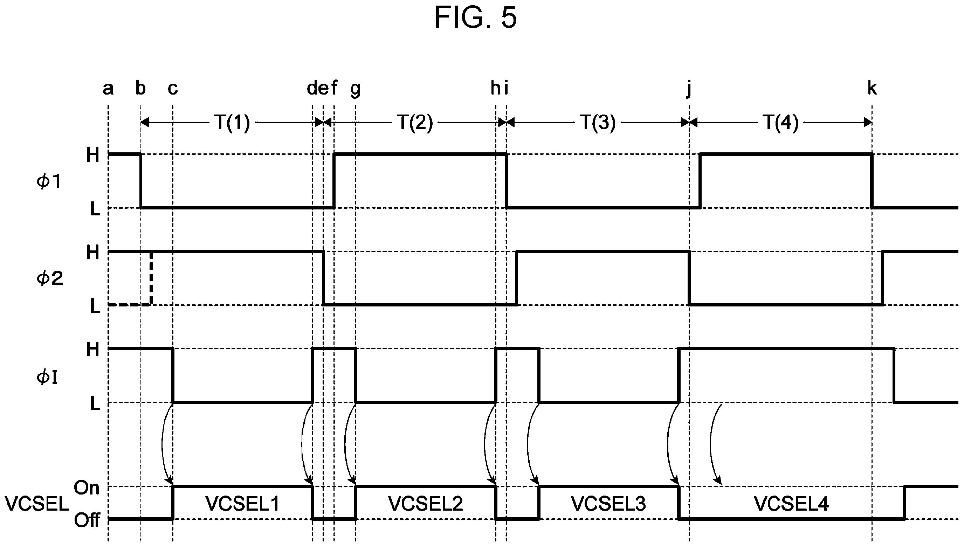

Fig. 5 is a timing chart for describing an example of the operations of the light source device 1 and the light-emitting chip 10. Fig. 5 is a timing chart of a portion that controls the lighted (emitting) and unlighted (non-emitting) states of four VCSELs, the VCSEL1 to the VCSEL4, of the light-emitting chip 10. Note that in Fig. 5, the VCSEL1, VCSEL2, and VCSEL3 are made to emit light, and the VCSEL4 is non-emitting.

In Fig. 5, time is assumed to elapse from a time a to a time k in alphabetical order. Control of the lighted or unlighted state (referred to as lighting control) of the VCSEL1, VCSEL2, VCSEL3, and VCSEL4 is controlled in periods T(1), T(2), T(3), and T(4), respectively. Here, the periods T(1), T(2), T(3), and so on are assumed to be the same length, and are referred to as the period(s) T when not being distinguished individually.

The first transfer signal ϕ1 supplied to the ϕ1 terminal (see Figs. 2, 3A, and 3B) and the second transfer signal ϕ2 supplied to the ϕ2 terminal (see Figs. 2, 3A, and 3B) are signals having the two potentials of "H" (0 V) and "L" (-5 V). Additionally, the waveforms of the first transfer signal ϕ1 and the second transfer signal ϕ2 repeat in units of two consecutive periods T (for example, the period T(1) and the period T(2)). Hereinafter, "H" (0 V) and "L" (-5 V) may be abbreviated to "H" and "L" in some cases.

The first transfer signal ϕ1 goes from "H" (0 V) to "L" (-5 V) at the start time b of the period T(1), and goes from "L" to "H" at the time f. Additionally, the level goes from "H" to "L" at the end time i of the period T(2). The second transfer signal ϕ2 is "H" (0 V) at the start time b of the period T(1), and goes from "H" (0 V) to "L" (-5 V) at the time e. Additionally, the level goes from "L" to "H" at the end time i of the period T(2). A comparison of the first transfer signal ϕ1 and the first transfer signal cp2 reveals that the second transfer signal cp2 corresponds to a displacement of the first transfer signal ϕ1 by one period T backward on the time axis. On the other hand, for the second transfer signal ϕ2, the waveform indicated by the dashed line in the period T(1) and the waveform in the period T(2) repeat from the period T(3). The waveform of the second transfer signal ϕ2 in the period T(1) is different than the waveform from the period T(3) because the period T(1) is the period in which the light source device 1 starts operating.

As described later, the paired transfer signals of the first transfer signal ϕ1 and the second transfer signal ϕ2 cause the ON state of the transfer thyristors T to be propagated in numerical order, and thereby specify the VCSEL of the same numeral as the transfer thyristor T in the ON state as the target to be lighted or unlighted (lighting control).

Next, the lighting signal ϕI supplied to the ϕI terminal (see Figs. 2, 3A, and 3B) will be described. The lighting signal ϕI is a signal having the two potentials of "H" (0 V) and "L" (-5 V). Here, the lighting signal ϕI will be described in the period T(1) of the lighting control for the VCSEL1. The lighting signal ϕI is "H" (0 V) at the start time b of the period T(1), and goes from "H" (0 V) to "L" (-5 V) at the time c. Additionally, the lighting signal ϕI goes from "L" to "H" at the time d, and maintains "H" at the time e.

The operations of the light source device 1 and the light-emitting chip 10 will be described by following the timing chart illustrated in Fig. 5, while also referencing Fig. 2. Note that the following describes the periods T(1) and T(2) of the lighting control for the VCSEL1 and VCSEL2.

### (1) Time a

At the time a, the reference potential supply unit 160 of the controller 110 of the light source device 1 sets the reference potential Vsub to "H" (0 V). The power supply potential supply unit 170 of the controller 110 sets the power supply potential Vga to "L" (-5 V). The transfer signal generation unit 120 of the controller 110 sets each of the first transfer signal ϕ1 and the second transfer signal ϕ2 to "H" (0 V). With this arrangement, the ϕ1 terminal and the ϕ2 terminal of the light-emitting chip 10 go to "H". The potential of the first transfer signal line 72 connected to the ϕ1 terminal through the current-limiting resistor R1 also goes to "H", and the potential of the second transfer signal line 73 connected to the ϕ2 terminal through the current-limiting resistor R2 also goes to "H" (see Fig. 2).

Additionally, the lighting signal generation unit 140 of the controller 110 sets the lighting signal ϕI to "H" (0 V). With this arrangement, the ϕI terminal of the light-emitting chip 10 goes to "H" through the current-limiting resistor RI, and the lighting signal line 75 connected to the ϕI terminal also goes to "H" (0 V).

The anode (p anode layer 85) of the setting thyristor S is connected to the cathode (n cathode (DBR) layer 83) of the VCSEL through the tunnel junction layer 84, and the anode (p anode (DBR) layer 81) of the VCSEL is connected to the Vsub terminal set to "H". The anode (p anode layer 85) of the transfer thyristor T is connected to the cathode (n cathode (DBR) layer 83) of the lower diode UD through the tunnel junction layer 84, and the anode (p anode (DBR) layer 81) of the lower diode UD is connected to the Vsub terminal set to "H".

The cathode of each of the odd-numbered transfer thyristors T1, T3, and T5 is connected to the first transfer signal line 72 and is set to "H" (0 V). The cathode of each of the even-numbered transfer thyristors T2, T4, and T6 is connected to the second transfer signal line 73 and is set to "H". Therefore, the transfer thyristor T is in the OFF state with the anode and the cathode both at "H". Likewise, the lower diode UD is also in the OFF state with the anode and the cathode both at "H".

The cathode terminal of the setting thyristor S is connected to the lighting signal line 75 at "H" (0 V). Therefore, the setting thyristor S is in the OFF state with the anode and the cathode both at "H". Likewise, the VCSEL is also in the OFF state with the anode and the cathode both at "H".

As described above, the gate Gt1 is connected to the cathode of the start diode SD. The gate Gt1 is connected to the power supply line 71 of the power supply potential Vga ("L" (-5 V)) through the power supply line resistor Rg1. Additionally, the anode terminal of the start diode SD is connected to the second transfer signal line 73, and is connected to the ϕ2 terminal at "H" (0 V) through the current-limiting resistor R2. Consequently, the start diode SD is forward biased, and the cathode of the start diode SD (the gate Gt1) goes to the voltage value (-1.5 V) obtained by subtracting the forward potential Vd (1.5 V) of the pn junction from the anode potential ("H" (0 V)) of the start diode SD. Also, when the gate Gt1 goes to - 1.5 V, the coupling diode D1 is forward biased because the anode (gate Gt1) is at -1.5 V and the cathode is connected to the power supply line 71 ("L" (-5 V)) through the power supply line resistor Rg2. Consequently, the potential of the gate Gt2 goes to -3 V, which is the potential obtained by subtracting the forward potential Vd (1.5 V) of the pn junction from the potential (-1.5 V) of the gate Gt1. Furthermore, the coupling diode D2 is forward biased because the anode (gate Gt1) is at -3 V and the cathode is connected to the power supply line 71 ("L" (-5 V)) through the power supply line resistor Rg2. Consequently, the potential of the gate Gt3 goes to -4.5 V, which is the potential obtained by subtracting the forward potential Vd (1.5 V) of the pn junction from the potential (-3 V) of the gate Gt2. However, the gates Gt numbered 4 and higher are not influenced by the anode of the start diode SD being at "H" (0 V), and the potential of these gates Gt is "L" (-5 V), the potential of the power supply line 71.

Note that because the gates Gt are the gates Gs, the potential of the gates Gs is the same as the potential of the gates Gt. Consequently, the threshold voltage of the transfer thyristor T and the setting thyristor S is the value obtained by subtracting the forward potential Vd (1.5 V) of the pn junction from the potential of the gates Gt and Gs. Namely, the threshold voltage of the setting thyristor S1 is -3 V, the threshold voltage of the transfer thyristor T2 and the setting thyristor S2 is -4.5 V, the threshold voltage of the transfer thyristor T3 and the setting thyristor S3 is -6 V, and the threshold voltage of the transfer thyristors T and setting thyristors S numbered 4 and higher is -6.5 V.

### (2) Time b

At the time b illustrated in Fig. 5, the first transfer signal ϕ1 goes from "H" (0 V) to "L" (-5 V). This causes the light source device 1 to start operating. When the first transfer signal ϕ1 goes from "H" to "L", the potential of the first transfer signal line 72 goes from "H" (0 V) to "L" (-5 V) through the ϕ1 terminal and the current-limiting resistor R1. Since the voltage applied to the transfer thyristor T1 is -3.3 V, the transfer thyristor T1 with a threshold voltage of -3 V turns on. At this time, a current flows through the lower diode UD1, causing the lower diode UD1 to switch from the OFF state to the ON state. By turning on the transfer thyristor T1, the potential of the first transfer signal line 72 goes to a potential close to -3.2 V (a negative potential having an absolute value greater than 3.2 V), which is obtained by subtracting the forward potential Vd (1.5 V) of the pn junction from the anode potential (the potential of -1.7 V applied to the lower diode UD1) of the transfer thyristor T1. Note that the threshold voltage of the transfer thyristor T3 is -6 V and the threshold voltage of the transfer thyristor T5 is -6.5 V. The voltage applied to the transfer thyristor T3 and the transfer thyristor T5 is -1.5 V, which is obtained by adding to -3.2 V the voltage of 1.7 V applied to the VCSEL, and thus the transfer thyristors T3 and T5 do not turn on. Meanwhile, since the second transfer signal ϕ2 is "H" (0 V) and the second transfer signal line 73 is "H" (0 V), the even-numbered transfer thyristors T do not turn on.

When the transfer thyristor T1 turns on, the potential of the gate Gt1/Gs1 goes to the anode potential "H" (0 V) of the transfer thyristor T1. Additionally, the potential of the gate Gt2 (gate Gs2) goes to -1.5 V, the potential of the gate Gt3 (gate Gs3) goes to -3 V, the potential of the gate Gt4 (Gs4) goes to -4.5 V, and the potential of the gates Gt (gates Gs) numbered 5 and higher goes to "L". With this arrangement, the threshold voltage of the setting thyristor S1 is -1.5 V, the threshold voltage of the transfer thyristor T2 and the setting thyristor S2 is -3 V, the threshold voltage of the transfer thyristor T3 and the setting thyristor S3 is -4.5 V, the threshold voltage of the transfer thyristor T4 and the setting thyristor S4 is -6 V, and the threshold voltage of the transfer thyristors T5, T6 and the setting thyristors S5, S6 is -6.5 V. However, because the first transfer signal line 72 is at -1.5 V due to the transfer thyristor T1 in the ON state, the odd-numbered transfer thyristors T in the OFF state do not turn on. Because the second transfer signal line 73 is at "H" (0 V), the even-numbered transfer thyristors T do not turn on. Because the lighting signal line 75 is at "H" (0 V), none of the VCSELs light up.

Immediately after the time b (here referring to when a steady state is reached after a change occurs in the thyristors and the like due to a change in the signal potential at the time b), the transfer thyristor T1 and the lower diode UD1 are in the ON state while the other transfer thyristors T, lower diodes UD, setting thyristors S, and VCSELs are in the OFF state.

### (3) Time c

At the time c, the lighting signal ϕI goes from "H" (0 V) to "L" (-5 V). When the lighting signal ϕI goes from "H" to "L", the lighting signal line 75 goes from "H" (0 V) to "L" (-5 V) through the current-limiting resistor RI and the ϕI terminal. This causes a voltage of - 3.3 V, which is obtained by adding the voltage 1.7 V applied to VCSEL, to be applied to the setting thyristor S1, thereby turning on the setting thyristor S1 having a threshold value of -1.5 V, and the VCSEL1 lights up (emits light). With this arrangement, the potential of the lighting signal line 75 goes to a potential close to -3.2 V. Note that the setting thyristor S2 has a threshold voltage of -3 V, but since the voltage applied to the setting thyristor S2 is -1.5 V, which is obtained by adding to -3.2 V the voltage 1.7 V applied to the VCSEL, the setting thyristor S2 does not turn on. Immediately after the time c, the transfer thyristor T1, the lower diode UD1, and the setting thyristor S1 are in the ON state, and the VCSEL1 is lighted (emitting light).

### (4) Time d

At the time d, the lighting signal ϕI goes from "L" (-5 V) to "H" (0 V). When the lighting signal ϕI goes from "L" to "H", the potential of the lighting signal line 75 goes from - 3.2 V to "H" (0 V) through the current-limiting resistor RI and the ϕI terminal. This causes both the cathode of the setting thyristor S1 and the anode of the VCSEL1 to go to "H", thereby turning off the setting thyristor S1 and causing the VCSEL1 to go dark (become unlighted). The lighted period of the VCSEL1 is the period during which the lighting signal ϕI is "L", lasting from the time c when the lighting signal ϕI goes from "H" to "L" until the time d when the lighting signal ϕI goes from "L" to "H". Immediately after the time d, the transfer thyristor T1 is in the ON state.

### (5) Time e

At the time e, the second transfer signal ϕ2 goes from "H" (0 V) to "L" (-5 V). At this point, the period T(1) of the lighting control for the VCSEL1 ends, and the period T(2) of the lighting control for the VCSEL2 begins. When the second transfer signal ϕ2 goes from "H" to "L", the potential of the second transfer signal line 73 goes from "H" to "L" through the ϕ2 terminal. As described above, the transfer thyristor T2 has a threshold voltage of -3 V, and therefore turns on. At this time, a current flows also through the lower diode UD2, causing the lower diode UD2 to switch from the OFF state to the ON state. With this arrangement, the potential of the gate terminal Gt2 (gate terminal Gs2) is "H" (0 V), the potential of the gate Gt3 (gate Gs3) is -1.5 V, the potential of the gate Gt4 (gate Gs4) is -3 V, the potential of the gate Gt5 (gate Gs5) is -4.5 V, and the potential of the gate Gt6 (gate Gs6) is -5 V. Immediately after the time e, the transfer thyristors T1, T2 and the lower diodes UD1, UD2 are in the ON state.

### (6) Time f

At the time f, the first transfer signal ϕ1 goes from "L" (-5 V) to "H" (0 V). When the first transfer signal ϕ1 goes from "L" to "H", the potential of the first transfer signal line 72 goes from "L" to "H" through the ϕ1 terminal. This causes both the anode and the cathode of the transfer thyristor T1 in the ON state to go to "H", and the transfer thyristor T1 turns off. At this time, both the anode and the cathode of the lower diode UD1 also go to "H", and the lower diode UD1 switches from the ON state to the OFF state. Thereafter, the potential of the gate Gt1 (gate Gs1) changes toward the power supply potential Vga ("L" (-5 V)) of the power supply line 71 through the power supply line resistor Rg1. This puts the coupling diode D1 in a state (reverse-biased) with a potential added in the direction of no current flow. Therefore, the gate Gt2 (gate Gs2) being "H" (0 V) does not influence the gate Gt1 (gate Gs1). In other words, for the transfer thyristor T having the gate Gt connected by the reversed biased coupling diode D, the threshold voltage is -6.5 V, and the transfer thyristor T no longer turns on even if the first transfer signal ϕ1 or the second transfer signal cp2 is at "L" (-5 V). Immediately after the time f, the transfer thyristor T2 and the lower diode UD2 are in the ON state.

### (7) Other

At the time g, when the lighting signal ϕI goes from "H" (0 V) to "L" (-5 V), the setting thyristor S2 turns on and the VCSEL2 lights up (emits light), similarly to the setting thyristor S1 and the VCSEL1 at the time c. At the time h, when the lighting signal ϕI goes from "L" (-5 V) to "H" (0 V), the setting thyristor S2 turns off and the VCSEL2 goes dark, similarly to the VCSEL1 and the setting thyristor S1 at the time d. Furthermore, at the time i, when the first transfer signal ϕ1 goes from "H" (0 V) to "L" (-5 V), the transfer thyristor T3 having a threshold voltage of -3 V turns on, similarly to the transfer thyristor T1 at the time b or the transfer thyristor T2 at the time e. At the time i, the period T(2) of the lighting control for the VCSEL2 ends, and the period T(3) of the lighting control for the VCSEL3 begins. Thereafter, the operations described above are repeated.

Note that when causing the VCSEL to remain dark (unlighted) without lighting up (emitting light), the lighting signal ϕI may simply be maintained at "H" (0 V), like the lighting signal ϕI indicated from the time j to the time k in the period T(4) of the lighting control for the VCSEL4 in Fig. 5. With this arrangement, even if the threshold voltage of the setting thyristor S4 is -1.5 V, the setting thyristor S4 does not turn on, and the VCSEL4 remains dark (unlighted).

As described above, the gate terminals Gt of the transfer thyristors T are interconnected by the coupling diodes D. Consequently, when the potential of one of the gates Gt changes, the potentials of the gates Gs connected to the gate Gt with the changed potential through the forward biased coupling diodes D also change. Additionally, the threshold voltage of the transfer thyristor T having a gate with a changed potential also changes. If the threshold voltage of the transfer thyristor T is higher than -3.3 V (negative value having a smaller absolute value), the transfer thyristor T turns on at the timing when the first transfer signal ϕ1 or the second transfer signal ϕ2 goes from "H" (0 V) to "L" (-5 V). Additionally, because the setting thyristor S with the gate Gs connected to the gate Gt of the transfer thyristor T in the ON state has a threshold voltage of -1.5 V, the setting thyristor S turns on when the lighting signal ϕI goes from "H" (0 V) to "L" (-5 V), and the VCSEL connected in series with the setting thyristor S lights up (emits light).

That is, switching one of transfer thyristors T to the ON state specifies which VCSEL is the target of the lighting control, and the lighting signal ϕI at "L" (-5 V) turns on the setting thyristor S connected in series with the VCSEL specified as the target of the lighting control and causes the VCSEL to light up. In other words, in the light-emitting chip 10, by transferring the ON state of the transfer thyristors T, the VCSELs light up sequentially. Note that the lighting signal ϕI at "H" (0 V) keeps the setting thyristor S in the OFF state and keeps the VCSEL in the unlighted state. That is, the lighting signal ϕI sets the lighted/unlighted state of the VCSEL.

In this way, in the light source device 1 of the exemplary embodiment has multiple elements (transfer thyristors T1 to T6, setting thyristors S1 to S6, VCSEL1 to VCSEL6, and so on), and the elements in the ON state among these multiple elements proceed one after another. With this arrangement, in the light source device 1 of the exemplary embodiment, the multiple transfer thyristors T1 to T6 in the transfer unit 12 of the light-emitting chip 10 are switched to the ON state individually according to the lighting control the controller 110. Additionally, the transfer thyristors T1 to T6 being switched to the ON state specifies which VCSEL is the target of the lighting control, and the multiple setting thyristors S1 to S6 in the light-emitting unit 11 are switched to the ON state individually. Additionally, each setting thyristor S being switched to the ON state causes the VCSEL corresponding to that setting thyristor S to emit light individually. Moreover, in the light source device 1 of the exemplary embodiment, the controller 110 and the transfer unit 12 of the light-emitting chip 10 are an example of a driving unit that individually drives and causes the multiple setting thyristors S to switch to the ON state. Also, in the light-emitting chip 10 of the exemplary embodiment, the portion of the light-emitting layer 82 included in each VCSEL that actually emits light in response to the supply of a current is the light-emitting area of each VCSEL.

As described above, in the light-emitting chip 10 of the exemplary embodiment, the setting thyristor S being switched to the ON state produces a state allowing a current to be supplied to the corresponding VCSEL. Thereafter, if a current large enough to induce light emission in the VCSEL is actually supplied to the VCSEL, the VCSEL emits light. Incidentally, in some cases, depending on the configuration of the light-emitting chip 10 and the control by the controller 110, after the setting thyristor S is switched to the ON state to produce a state allowing a current to be supplied to the corresponding VCSEL, the ON signal to the setting thyristor S may be stopped before the VCSEL emits light while the VCSEL remains ready to emit light if a current is supplied. Even in such cases, by supplying to the VCSEL a current large enough to induce light emission in the VCSEL, it is possible to cause the VCSEL to emit light after the setting thyristor S is switched to the OFF state. Moreover, in such cases, the setting thyristor S switches to the OFF state at the moment when the VCSEL actually emits light after having switched to the ON state to allow the VCSEL to emit light. In the exemplary embodiment, "the thyristor (setting thyristor S) is switched to the ON state to cause the light-emitting element (VCSEL) to emit light" means that the setting thyristor S being switched to the ON state produces a state allowing the corresponding VCSEL to emit light in response to the supply of a current. Moreover, after the setting thyristor S has been switched to the state allowing the VCSEL to emit light in response to the supply of a current, at the moment when a current is being supplied to the VCSEL and the VCSEL is actually emitting light, the setting thyristor S may be maintained in the ON state or have been switched to the OFF state.

### (Light emitted from setting thyristor S)

Incidentally, since the setting thyristor S is formed from a compound semiconductor as described above, the setting thyristor S may emit light from between the n gate layer 86 and the p gate layer 87 when switched to the ON state. Moreover, in some cases, the setting thyristor S may emit light from between the n gate layer 86 and the p gate layer 87 if the value of the current flowing between the p anode layer 85 and the n cathode layer 88 increases.

Consider the case of a light source device 1 (light-emitting chip 10) having multiple VCSELs and setting thyristors S formed on the same substrate 80, in which VCSEL lighting control is performed so that one VCSEL (for example, VCSEL1) selected from the multiple VCSELs lights up while the other VCSELs (for example, VCSEL2 to VCSEL6) are unlighted. In this case, the setting thyristor S1 connected to the VCSEL1 to emit light is switched to the ON state by the controller 110, and the VCSEL1 lights up accordingly. On the other hand, at the moment when the setting thyristor S1 is switched to the ON state, the other setting thyristors S2 to S6, which are connected to the other VCSEL2 to VCSEL6 not to light up, remain in the OFF state.

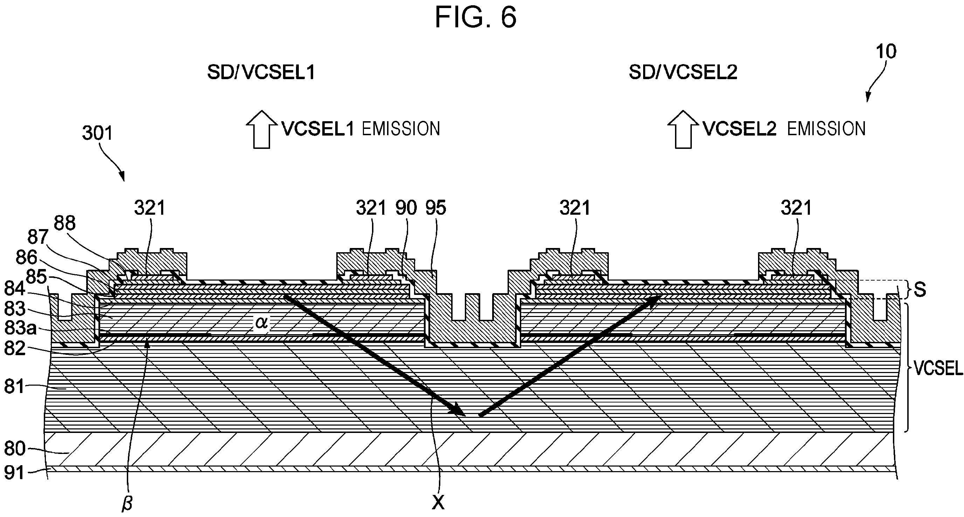

Additionally, if the setting thyristor S1 is switched to the ON state, light may be emitted from the setting thyristor S1 in some cases due to the current supplied to the setting thyristor S1. Fig. 6 is a diagram for describing an example of the behavior of light emitted from the setting thyristor S when the substrate 80 does not absorb the light emitted from the setting thyristor S. Fig. 6, like Fig. 4 described above, illustrates the island 301 in which the VCSEL1 and the setting thyristor S1 are layered and the island (no reference sign) in which the VCSEL2 and the setting thyristor S2 are layered. Light emitted from the setting thyristor S1 is propagated through the semiconductor layers and the like forming the setting thyristor S1 and the VCSEL1. If the substrate 80 does not absorb the light emitted from the setting thyristor S, the light emitted from the setting thyristor S may reach another setting thyristor S (for example, the setting thyristor S2) adjacent to the setting thyristor S1 as-is without a change of wavelength, as indicated by the arrow X in Fig. 6. In particular, if a portion of the semiconductor layers forming the VCSELs is continuous between adjacent VCSELs as described above, the light emitted from the setting thyristor S1 is easily propagated to the setting thyristor S2 adjacent through the semiconductor layers.

As described above, in this example, the setting thyristor S2 is in the OFF state to keep the VCSEL2 corresponding to the setting thyristor S2 unlighted. However, if light emitted from the setting thyristor S1 is propagated as-is to the setting thyristor S2 and absorbed by the gate layers (n gate layer 86, p gate layer 87) of the setting thyristor S2 to generate an electromotive force, the setting thyristor S2 is switched to the ON state. Then, as the setting thyristor S2 is switched to the ON state, the VCSEL2, which was to be unlighted, emits light. In this way, if light emitted from a setting thyristor S is absorbed by another setting thyristor S, an unlighted VCSEL not specified as the target of the lighting control among the multiple VCSELs may accidentally light up in some cases. In such cases, accurate lighting control of the multiple VCSELs in the light source device 1 is difficult.

### (Details of substrate 80 and semiconductor layers forming setting thyristor S and VCSEL)

The light-emitting chip 10 of the exemplary embodiment has a substrate 80 that absorbs light emitted from the setting thyristor S and emits light that is not absorbed by the gate layers (n gate layer 86, p gate layer 87) of the setting thyristor S. In general, a compound semiconductor absorbs light with a shorter wavelength (that is, with a higher band gap energy) than the wavelength corresponding to the band gap energy of the compound semiconductor itself. In addition, upon absorbing light, a compound semiconductor emits light corresponding to the band gap energy of the compound semiconductor itself. Consequently, light emitted from the setting thyristor S may be absorbed by a semiconductor with a lower band gap energy than the band gap energy corresponding to light emitted from the setting thyristor S. The substrate 80 of the exemplary embodiment is formed from a semiconductor with a lower band gap energy than the band gap energy corresponding to light emitted from the setting thyristor S. Hereinafter, the substrate 80 and each of the semiconductor layers forming the setting thyristor S and the VCSEL of the light-emitting chip 10 to which the exemplary embodiment is applied will be described in further detail and with reference to Fig. 4 and other drawings.

### <Layer configuration of setting thyristor S>

As described above, the setting thyristor S is formed from the p anode layer 85, the n gate layer 86, the p gate layer 87, and the n cathode layer 88 which are layered on the tunnel junction layer 84. As described above, the p anode layer 85, the n gate layer 86, the p gate layer 87, and the n cathode layer 88 are formed from a III-V compound semiconductor.

In the exemplary embodiment, the n gate layer 86 and the p gate layer 87 are preferably formed from a III-V compound semiconductor containing Al. Examples of the III-V compound semiconductor containing Al that forms the n gate layer 86 and the p gate layer 87 include AlGaAs, AlGaN, and AlAs, of which AlGaAs is preferably used. By using a III-V compound semiconductor containing Al, such as AlGaAs, for example, as the n gate layer 86 and the p gate layer 87, the band gap energy corresponding to light emitted from the n gate layer 86 and the p gate layer 87 may be increased compared to the case of using a III-V compound semiconductor not containing Al, such as GaAs, for example, as the n gate layer 86 and the p gate layer 87. With this arrangement, light emitted from the n gate layer 86 and the p gate layer 87 is absorbed easily by the substrate 80. Also, causing light emitted from the n gate layer 86 and the p gate layer 87 to be absorbed by the substrate 80 makes it difficult for light (re-emitted light) emitted again from the substrate 80 to be absorbed by the n gate layer 86 and the p gate layer 87 of the adjacent setting thyristor S. This arrangement keeps the adjacent setting thyristor S from being switched to the ON state. Note that in the case in which the n gate layer 86 and the p gate layer 87 are formed from a semiconductor not containing Al as an exemplary modification, GaInAsP is preferably used, for example.

Also, in the case in which the n gate layer 86 and the p gate layer 87 of the setting thyristor S of the exemplary embodiment are formed from a III-V compound semiconductor containing Al, it is preferable if the n gate layer 86 and the p gate layer 87 have a low Al content ratio compared to the Al-containing semiconductor layers in the VCSEL. Note that "the n gate layer 86 and the p gate layer 87 have a low Al content ratio compared to the Al-containing semiconductor layers in the VCSEL" does not refer only the case in which the Al content ratio is lower than all of the semiconductor layers forming the VCSEL. The above means that the n gate layer 86 and the p gate layer 87 have a low Al content ratio compared to the semiconductor layers occupying at least half of the entire VCSEL in terms of thickness. Although details are described later, the n gate layer 86 and the p gate layer 87 of the exemplary embodiment have a low Al content ratio compared to the p anode (DBR) layer 81 and the n cathode (DBR) layer 83 as the Al-containing semiconductor layers in the VCSEL.

Also, in the case in which the n gate layer 86 and the p gate layer 87 are formed from a III-V compound semiconductor containing Al, the n gate layer 86 and the p gate layer 87 preferably have an Al content ratio equal to or greater than 1%, more preferably equal to or greater than 7%, even more preferably equal to or greater than 10%. In the case in which the Al content ratio of the n gate layer 86 and the p gate layer 87 is less than 1%, light emitted from between the n gate layer 86 and the p gate layer 87 is absorbed less easily by the substrate 80 and the light may be propagated easily to the adjacent setting thyristor S in some cases.

Also, the n gate layer 86 and the p gate layer 87 preferably have an Al content ratio less than 30%, more preferably less than 20%. In some cases, the manufacturing process of the light-emitting chip 10 may include a process in which the n gate layer 86 and the p gate layer 87 are exposed to air. In such cases, if the Al content ratio of the n gate layer 86 and the p gate layer 87 is equal to or greater than 30%, the surfaces of the n gate layer 86 and the p gate layer 87 are easily oxidized by the air. This may result in poor connections between the n gate layer 86, the p gate layer 87, and the electrodes provided on these layers (for example, the connection between the p gate layer 87 and the p ohmic electrode 331). Also, among the semiconductor layers forming the setting thyristor S, the n gate layer 86 and the p gate layer 87 generally have a low Al content ratio compared to the p anode layer 85 and the n cathode layer 88. In addition, the driving voltage of the setting thyristor S is determined by the n gate layer 86 and the p gate layer 87, that is, the semiconductor layers with a low Al content ratio among the semiconductor layers forming the setting thyristor S. Moreover, the lower the Al content ratio of the n gate layer 86 and the p gate layer 87 is, the lower the driving voltage of the setting thyristor S is, and the higher the Al content ratio of the n gate layer 86 and the p gate layer 87 is, the higher the driving voltage of the setting thyristor S is. Consequently, if the Al content ratio of the n gate layer 86 and the p gate layer 87 is equal to or greater than 30%, the driving voltage of the setting thyristor S may be too high, which is not preferable.

As described later, the Al content ratio of the n gate layer 86 and the p gate layer 87 preferably is determined by the relationship between the substrate 80 and the p anode (DBR) layer 81 and n cathode (DBR) layer 83 of the VCSEL. Note that in the description of the exemplary embodiment, the Al content ratio of the III-V compound semiconductor containing Al means the ratio of the number of atoms of Al with respect to the sum of the number of atoms of group III elements in the III-V compound semiconductor. For example, the Al content ratio of AlGaAs means the ratio of the number of atoms of Al with respect to the sum of the number of atoms of Al and Ga in AlGaAs.

For the p anode layer 85 of the setting thyristor S as above, p-type AlGaAs with an impurity concentration of 1×10¹⁸/cm³ may be used, for example. The Al content ratio of the p anode layer 85 may be changed in the range from 0% to 100%. For the n gate layer 86, n-type AlGaAs with an impurity concentration of 1×10¹⁷/cm³ may be used, for example. As described later, the Al content ratio of the n gate layer 86 may simply be determined by the relationship between the substrate 80 and the p anode (DBR) layer 81 and n cathode (DBR) layer 83 of the VCSEL. In the exemplary embodiment, AlGaAs, which has a low Al content ratio compared to the low refractive index layers of the p anode (DBR) layer 81 and the high refractive index layers of the n cathode (DBR) layer 83 described later, may be used as the n gate layer 86. For the p gate layer 87, p-type AlGaAs with an impurity concentration of 1×10¹⁷/cm³ may be used, for example. As described later, the Al content ratio of the n gate layer 86 may simply be determined by the relationship between the substrate 80 and the p anode (DBR) layer 81 and n cathode (DBR) layer 83 of the VCSEL. In the exemplary embodiment, AlGaAs, which has a low Al content ratio compared to the low refractive index layers of the p anode (DBR) layer 81 and the high refractive index layers of the n cathode (DBR) layer 83 described later, may be used as the p gate layer 87. For the n cathode layer 88, n-type AlGaAs with an impurity concentration of 1×10¹⁸/cm³ may be used, for example. The Al content ratio of the p anode layer 85 may be changed in the range from 0% to 100%.

### <Layer configuration of VCSEL>

The VCSEL is formed from the p anode (DBR) layer 81, the light-emitting layer 82, and the n cathode (DBR) layer 83 which are layered on the substrate 80. The VCSEL causes laser oscillation by resonating light in the light-emitting layer 82 sandwiched between the p anode (DBR) layer 81 and the n cathode (DBR) layer 83. Laser oscillation occurs in the VCSEL when the reflectance of light by the p anode (DBR) layer 81 and the n cathode (DBR) layer 83 is equal to or greater than 99%, for example.

The VCSEL of the exemplary embodiment preferably transmits light emitted from the setting thyristor S. If the semiconductor layers absorb the light, heat buildup may occur as a consequence. In the exemplary embodiment, the VCSEL transmits light emitted from the setting thyristor S, thereby suppressing heat buildup associated with absorption of the light emitted from the setting thyristor S by the semiconductor layers forming the VCSEL compared to the case in which the VCSEL does not transmit the light emitted from the setting thyristor S. This arrangement suppresses a degradation in the characteristics of the VCSEL due to a temperature rise in the VCSEL.

Note that "the VCSEL transmits light emitted from the setting thyristor S" does not mean only the case of transmitting all of the light emitted from the setting thyristor S and may simply mean transmitting at least some of the light emitted from the setting thyristor S; preferably, at least 70% of the light emitted from the setting thyristor S is transmitted. Also, the semiconductor layers forming the VCSEL may include a layer that easily transmits light emitted from the setting thyristor S and a layer that hardly transmits light emitted from the setting thyristor S.

As described above, the VCSEL includes the p anode (DBR) layer 81, the light-emitting layer 82, and the n cathode (DBR) layer 83. In the VCSEL of the exemplary embodiment, the band gap energy of at least the p anode (DBR) layer 81 and the n cathode (DBR) layer 83 is higher than the band gap energy corresponding to light emitted from the setting thyristor S. In this case, the p anode (DBR) layer 81 and the n cathode (DBR) layer 83 do not absorb light emitted from the setting thyristor S by band edge absorption due to the difference in band gap energy. Note that the p anode (DBR) layer 81 and the n cathode (DBR) layer 83 contain impurities. In a compound semiconductor, as the impurity concentration increases, the numbers of electrons and holes (free carriers) free to move within the semiconductor increase, facilitating light absorption by free carrier absorption. Consequently, in some cases, the p anode (DBR) layer 81 and the n cathode (DBR) layer 83 may absorb light emitted from the setting thyristor S by free carrier absorption due to the impurities. However, the amount of light absorbed by free carrier absorption is generally small compared to band edge absorption. Therefore, even if light emitted from the setting thyristor S is absorbed by free carrier absorption, the amount of light emitted from the setting thyristor S that is transmitted in the p anode (DBR) layer 81 and the n cathode (DBR) layer 83 is hardly reduced.

The p anode (DBR) layer 81 and the n cathode (DBR) layer 83 are examples of multilayer reflective layers, and as described above, are DBR layers in which multiple semiconductor layers with refractive index differences are layered. Moreover, the p anode (DBR) layer 81 has a configuration in multiple high refractive index layers with a relatively high refractive index and low refractive index layers with a relatively low refractive index are layered alternately. Note that the high refractive index layers having a "relatively high refractive index" means that the refractive index is high compared to the low refractive index layers. Similarly, the low refractive index layers having a "relatively low refractive index" means that the refractive index is low compared to the high refractive index layers. The n cathode (DBR) layer 83 has a configuration in multiple high refractive index layers with a relatively high refractive index and low refractive index layers with a relatively low refractive index are layered alternately, similarly to the p anode (DBR) layer 81.

In the exemplary embodiment, the high refractive index layers and the low refractive index layers of the p anode (DBR) layer 81 are preferably formed from a III-V compound semiconductor containing Al and doped with p-type impurities. Like the n gate layer 86 and the p gate layer 87 of the setting thyristor S, examples of the III-V compound semiconductor forming the high refractive index layers and the low refractive index layers of the p anode (DBR) layer 81 include AlGaAs, AlGaN, and AlAs, of which AlGaAs is preferably used.

More specifically, the p anode (DBR) layer 81 preferably includes high refractive index layers which are an example of a first semiconductor layer formed from AlGaAs, and low refractive index layers which are an example of a second semiconductor layer formed from AlGaAs with a high Al content ratio compared to the high refractive index layers. In addition, in the p anode (DBR) layer 81, the AlGaAs forming the high refractive index layers preferably has a high Al content ratio compared to the AlGaAs forming the n gate layer 86 and the p gate layer 87 of the setting thyristor S.

In a III-V compound semiconductor containing Al, the higher the Al content ratio is, the higher the band gap energy tends to be, and the lower the Al content ratio is, the lower the band gap energy tends to be. Accordingly, the band gap energy of the high refractive index layers and the low refractive index layers of the p anode (DBR) layer 81 is high compared to the band gap energy corresponding to light emitted from the setting thyristor S. As a result, light emitted from the setting thyristor S is easily transmitted without undergoing band edge absorption in the high refractive index layers and the low refractive index layers of the p anode (DBR) layer 81.

Similarly, the high refractive index layers and the low refractive index layers of the n cathode (DBR) layer 83 are preferably formed from a III-V compound semiconductor containing Al and doped with n-type impurities. Like the p anode (DBR) layer 81, examples of the III-V compound semiconductor forming the high refractive index layers and the low refractive index layers of the n cathode (DBR) layer 83 include AlGaAs, AlGaN, and AlAs, of which AlGaAs is preferably used.

More specifically, the n cathode (DBR) layer 83 preferably includes high refractive index layers which are another example of a first semiconductor layer formed from AlGaAs, and low refractive index layers which are another example of a second semiconductor layer formed from AlGaAs with a high Al content ratio compared to the high refractive index layers. In addition, in the n cathode (DBR) layer 83, the AlGaAs forming the high refractive index layers preferably has a high Al content ratio compared to the AlGaAs forming the n gate layer 86 and the p gate layer 87 of the setting thyristor S. Accordingly, the band gap energy of the high refractive index layers and the low refractive index layers of the n cathode (DBR) layer 83 is high compared to the band gap energy corresponding to light emitted from the setting thyristor S. As a result, light emitted from the setting thyristor S is easily transmitted without undergoing band edge absorption in the high refractive index layers and the low refractive index layers of the n cathode (DBR) layer 83.

Also, in the case in which the high refractive index layers and the low refractive index layers of the p anode (DBR) layer 81 and the n cathode (DBR) layer 83 are formed from a III-V compound semiconductor containing Al, the Al content ratio is preferably less than 30%. If the high refractive index layers and the low refractive index layers of the p anode (DBR) layer 81 and the n cathode (DBR) layer 83 have an Al content ratio equal to or greater than 30%, the reflectance, by the p anode (DBR) layer 81 and the n cathode (DBR) layer 83, of light emitted from the light-emitting layer 82 may be lowered in some cases.

Each high refractive index layer in the p anode (DBR) layer 81 has a film thickness in the range equal to or greater than (λ/4nₚ₁) × 0.4 and less than or equal to (λ/4nₚ₁) × 1.2, and is preferably λ/4nₚ₁. Here, λ is the wavelength of light emitted from the light-emitting layer 82 of the VCSEL, and nₚ₁ is the refractive index of the high refractive index layers of the p anode (DBR) layer 81. Similarly, each high refractive index layer in the n cathode (DBR) layer 83 has a film thickness in the range equal to or greater than (k/4nₙ₁) × 0.4 and less than or equal to (λ/4nₙ₁) × 1.2, and is preferably λ/4nₙ₁. Here, nₙ₁ is the refractive index of the high refractive index layers of the n cathode (DBR) layer 83.

Note that each high refractive index layer in the p anode (DBR) layer 81 preferably has a film thickness such that the high refractive index layers and the low refractive index layers of the p anode (DBR) layer 81 have a combined film thickness of λ/2. Consequently, in the case in which the high refractive index layers of the p anode (DBR) layer 81 are thinner than λ/4nₚ₁, for example, the low refractive index layers of the p anode (DBR) layer 81 may simply be thicker than λ/4nₚ₂ (where nₚ₂ is the refractive index of the low refractive index layers of the p anode (DBR) layer 81). Similarly, each high refractive index layer in the n cathode (DBR) layer 83 has a film thickness such that the high refractive index layers and the low refractive index layers of the n cathode (DBR) layer 83 have a combined film thickness of λ/2. Consequently, in the case in which the high refractive index layers of the n cathode (DBR) layer 83 are thinner than λ/4nₙ₁, for example, the low refractive index layers of the n cathode (DBR) layer 83 may simply be thicker than λ/4nₙ₂ (where nₙ₂ is the refractive index of the low refractive index layers of the n cathode (DBR) layer 83).

In the VCSEL of the exemplary embodiment, the n cathode (DBR) layer 83 preferably has a high transmittance of light emitted from the setting thyristor S compared to the p anode (DBR) layer 81. In other words, it is preferable if, compared to the p anode (DBR) layer 81, the n cathode (DBR) layer 83 hardly absorbs light emitted from the setting thyristor S. The n cathode (DBR) layer 83 is more distant from the substrate 80 compared to the p anode (DBR) layer 81. Therefore, if light emitted from the setting thyristor S is absorbed by the n cathode (DBR) layer 83 and heat is generated, the heat generated in the n cathode (DBR) layer 83 is hardly dissipated to the outside through the substrate 80. In the exemplary embodiment, by configuring the n cathode (DBR) layer 83 to have a high transmittance of light emitted from the setting thyristor S, heat buildup in the n cathode (DBR) layer 83 is suppressed, and a degradation in the characteristics of the VCSEL due to a temperature rise in the VCSEL is suppressed.

Also, in the VCSEL of the exemplary embodiment, the n cathode (DBR) layer 83 provided with the current narrowing layer 83a preferably has a high transmittance of light emitted from the setting thyristor S compared to the p anode (DBR) layer 81, which does not have a current narrowing layer. As described above, a current blocking section β where a current flows hardly and a current passing section α where a current flows easily are formed in the current narrowing layer 83a. Furthermore, in the VCSEL, since a current is concentrated in the current passing section α, the light-emitting layer 82 emits light near the current passing section α. In the exemplary embodiment, by configuring the n cathode (DBR) layer 83 provided with the current narrowing layer 83a to have a high transmittance of light emitted from the setting thyristor S, light emitted from the setting thyristor S is absorbed less easily near the current passing section α, thereby making the light-emitting layer 82 less susceptible to heat generated due to the absorption of light emitted from the setting thyristor S.

Also, in the VCSEL of the exemplary embodiment, the transmittance of light emitted from the setting thyristor S may be different among the multiple semiconductor layers forming the p anode (DBR) layer 81 and the n cathode (DBR) layer 83. Specifically, it is preferable if the p anode (DBR) layer 81 has a higher transmittance of light emitted from the setting thyristor S the closer the semiconductor layer is to the light-emitting layer 82 (that is, the higher the semiconductor layer is in Fig. 4). Similarly, it is preferable if the n cathode (DBR) layer 83 has a higher transmittance of light emitted from the setting thyristor S the closer the semiconductor layer is to the light-emitting layer 82 (that is, the lower the semiconductor layer is in Fig. 4). By adopting such a configuration, light emitted from the setting thyristor S is absorbed less easily in the semiconductor layers close to the light-emitting layer 82, thereby making the light-emitting layer 82 less susceptible to heat generated due to the absorption of light emitted from the setting thyristor S.

The p anode (DBR) layer 81 of the VCSEL as above may be, for example, a semiconductor layer formed from 40 alternating pairs of a low refractive index layer formed from AlGaAs doped with p-type impurities and high refractive index layer formed from AlGaAs doped with p-type impurities and having a low Al content ratio compared to the low refractive index layer. Note that the Al content ratio in the AlGaAs forming the low refractive index layers of the p anode (DBR) layer 81 and the Al content ratio in the AlGaAs forming the high refractive index layers may simply be set to meet the conditions described above. Also, the n cathode (DBR) layer 83 may be, for example, a semiconductor layer formed from 19 alternating pairs of a low refractive index layer formed from AlGaAs doped with n-type impurities and high refractive index layer formed from AlGaAs doped with n-type impurities and having a low Al content ratio compared to the low refractive index layer. Similarly, the Al content ratio in the AlGaAs forming the low refractive index layers of the n cathode (DBR) layer 83 and the Al content ratio in the AlGaAs forming the high refractive index layers may simply be set to meet the conditions described above.

Also, the light-emitting layer 82 may be, for example, a semiconductor layer in which a well layer formed from GaN, InGaN, AlGaN, or the like and a barrier layer formed from AlGaN, GaN, or the like are layered alternately. In general, the light-emitting layer 82 has a low band gap energy compared to the p anode (DBR) layer 81 and the n cathode (DBR) layer 83, and light emitted from the setting thyristor S may be absorbed by band edge absorption in some cases. Moreover, in the well layer and barrier layer of the light-emitting layer 82, light emitted from the setting thyristor S may be absorbed by band edge absorption in some cases. However, since the well layer and the barrier layer of the light-emitting layer 82 are thin compared to the p anode (DBR) layer 81 and the n cathode (DBR) layer 83, not much light emitted from the setting thyristor S is absorbed, and the light-emitting layer 82 is hardly influenced by the absorption of light emitted from the setting thyristor S.

### <Configuration of substrate 80>

As described above, the substrate 80 of the exemplary embodiment is a p-type substrate 80. For example, a substrate formed from a III-V compound semiconductor allowing for the epitaxial growth of semiconductor layers such as the p anode (DBR) layer 81, the light-emitting layer 82, and the n cathode (DBR) layer 83 forming the VCSEL may be used as the substrate 80. In the exemplary embodiment, the substrate 80 is formed from a semiconductor with a lower band gap energy than the band gap energy corresponding to light emitted from the setting thyristor S. More specifically, for the substrate 80, a substrate formed from a III-V compound semiconductor with a low Al content ratio compared to the n gate layer 86 and the p gate layer 87 forming the setting thyristor S is used preferably, and a GaAs substrate not containing Al (that is, the Al content ratio is 0%) is used more preferably. Note that although the exemplary embodiment describes a configuration for the case of using a p-type substrate 80 containing p-type impurities, a substrate 80 containing n-type impurities may also be used, and an intrinsic (i) substrate that is not doped with impurities may also be used.

In the VCSEL, light emitted from the setting thyristor S and transmitted through the p anode (DBR) layer 81 and the n cathode (DBR) layer 83 reaches the substrate 80. Thereafter, if the substrate 80 is formed from a semiconductor with a lower band gap energy than the band gap energy corresponding to the light emitted from the setting thyristor S, the light emitted from the setting thyristor S is absorbed by the substrate 80, and light corresponding to the band gap energy of the substrate 80 is emitted from the substrate 80. Moreover, the band gap energy of the light (re-emitted light) emitted from the substrate 80 is lower than the band gap energy of the n gate layer 86 and the p gate layer 87 of the setting thyristor S. Consequently, in the exemplary embodiment, re-emitted light emitted from the substrate 80 is not absorbed by the n gate layer 86 and the p gate layer 87 of the setting thyristor S. This arrangement keeps the adjacent setting thyristor S from being switched to the ON state by re-emitted light from the substrate 80.

### (Behavior of light emitted from setting thyristor S)

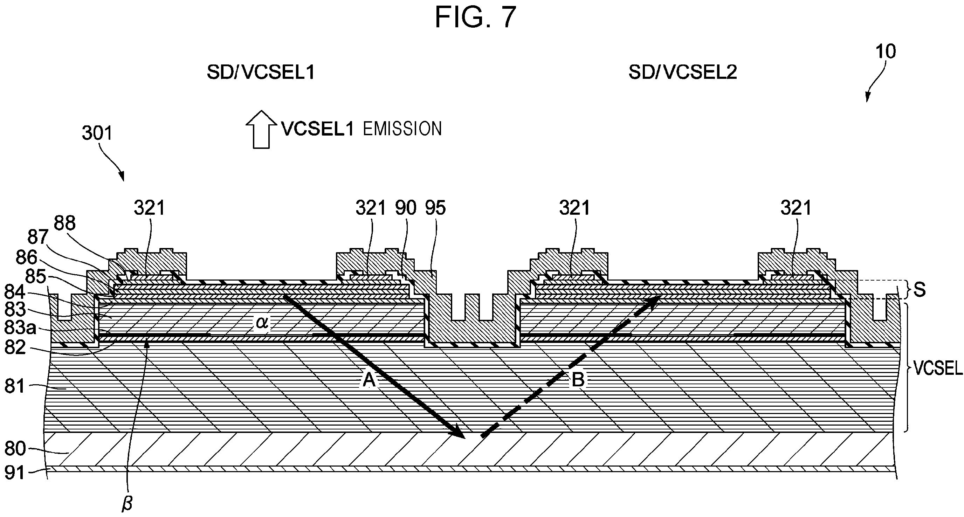

Next, the behavior of light emitted from the setting thyristor S will be described. Fig. 7 is a diagram for describing an example of the behavior of light emitted from the setting thyristor S in the light-emitting chip 10 to which the exemplary embodiment is applied. Fig. 7, like Fig. 4 described above, illustrates the island 301 in which the VCSEL1 and the setting thyristor S1 are layered and the island (no reference sign) in which the VCSEL2 and the setting thyristor S2 are layered. The example described here, like the example illustrated in Fig. 6, is of a case in which the setting thyristor S1 is switched to the ON state and light is emitted from the setting thyristor S1.

As described above, in the light-emitting chip 10 of the exemplary embodiment, the VCSEL absorbs light emitted from the setting thyristor S1. Specifically, light emitted from between the n gate layer 86 and the p gate layer 87 of the setting thyristor S1 is propagated to the VCSEL1 side located below the setting thyristor S1, as indicated by the arrow A in Fig. 7. Thereafter, the light emitted from the setting thyristor S1 is transmitted through the n cathode (DBR) layer 83, p anode (DBR) layer 81, and the like forming the VCSEL. As described above, causing the light emitted from the setting thyristor S1 to be transmitted through the VCSEL suppresses heat buildup due to the absorption, by the VCSEL, of the light emitted from the setting thyristor S1, and suppresses a degradation in the characteristics of the VCSEL.

Thereafter, the light emitted from the setting thyristor S1 and transmitted through the VCSEL reaches the substrate 80. As described above, the substrate 80 has a lower band gap energy than the band gap energy corresponding to the light emitted from the setting thyristor S1 such as GaAs. Consequently, the light emitted from the setting thyristor S1 and reaching the substrate 80 is absorbed by the substrate 80. Thereafter, light (re-emitted light) of a long wavelength corresponding to the band gap energy of the substrate 80 is emitted from the substrate 80, as indicated by the arrow B in Fig. 7. Moreover, the light (re-emitted light) of a long wavelength corresponding to the band gap energy of the substrate 80 is emitted from the substrate 80 toward the VCSEL and setting thyristor S layered on the substrate 80. The re-emitted light emitted from the substrate 80 is less energetic than the band gap energy of the n gate layer 86 and p gate layer 87, and thus even if the re-emitted light reaches the setting thyristor S2, the re-emitted light is not absorbed by the setting thyristor S2. Consequently, the setting thyristor S2 is not switched to the ON state by the re-emitted light emitted from the substrate 80.

As described above, in the light-emitting chip 10 of the exemplary embodiment, the substrate 80 absorbs light emitted from the setting thyristor S and emits light that is not absorbed by the n gate layer 86 and p gate layer 87 of the setting thyristor S. This arrangement makes it possible to suppress the direct propagation of light emitted from the setting thyristor S to another setting thyristor S that switches the other setting thyristor S to the ON state, thereby suppressing accidental lighting of the VCSEL not intended to emit light compared to the case in which the substrate 80 does not absorb light emitted from the setting thyristor S.

Note that the exemplary embodiment is described by taking an example in which, if light is emitted from the setting thyristor S as a thyristor, the substrate 80 absorbs the light emitted from the setting thyristor S. As described above, in the light-emitting chip 10 of the exemplary embodiment, the transfer thyristor T has a layer configuration similar to the setting thyristor S, and when the transfer thyristor T is switched to the ON state, light may be emitted from between the n gate layer 86 and the p gate layer 87 of the transfer thyristor T in some cases. In the light-emitting chip 10 of the exemplary embodiment, similarly to the example described above, the substrate 80 absorbs light emitted from the transfer thyristor T and emits light that is not absorbed by the n gate layer 86 and the p gate layer 87 of the transfer thyristor T. With this arrangement, in the light-emitting chip 10, the direct propagation of light emitted from the transfer thyristor T to another transfer thyristor T or the setting thyristor S is suppressed, and accidental lighting of the VCSEL not intended to emit light is suppressed.

### (Method of manufacturing light-emitting chip 10)

Next, an example of a method of manufacturing the light-emitting chip 10 to which the exemplary embodiment is applied will be described. The light-emitting chip 10 is formed through a semiconductor stack formation process, an n ohmic electrode (such as the n ohmic electrodes 321, 323, and 324) formation process, a semiconductor stack isolation process, a current blocking section β formation process, etching processes, a protective layer 90 formation process, and a wiring and electrode formation process.

In the semiconductor stack formation process, the p anode (DBR) layer 81, light-emitting layer 82, n cathode (DBR) layer 83, tunnel junction layer 84, p anode layer 85, n gate layer 86, p gate layer 87, and n cathode layer 88 are formed in the above order by epitaxial growth on the substrate 80 to form a semiconductor stack. These semiconductor layers are layered by metalorganic chemical vapor deposition (MOCVD) or molecular beam epitaxy (MBE), for example, to form the semiconductor stack. The p anode (DBR) layer 81, light-emitting layer 82, and n cathode (DBR) layer 83 are an example of a first semiconductor stack to be worked into the light-emitting element. Also, the p anode layer 85, n gate layer 86, p gate layer 87, and n cathode layer 88 provided on the tunnel junction layer 84 are an example of a second semiconductor stack to be worked into multiple thyristors (setting thyristor S, transfer thyristor T). Note that the substrate 80 and the semiconductor stack epitaxially grown on the substrate 80 are an example of a multilayer semiconductor substrate.

Next, in the n ohmic electrode formation process, first, the n ohmic electrodes 321, 323, 324, and the like are formed on the n cathode layer 88. The n ohmic electrodes (n ohmic electrodes 321, 323, 324, and the like) are, for example, Ge-containing Au (AuGe), which easily makes ohmic contact with an n-type semiconductor layer such as the n cathode layer 88. Additionally, the n ohmic electrodes (n ohmic electrodes 321, 323, 324, and the like) are formed by a process such as lift-off, for example.

Next, in the semiconductor stack isolation process, the n cathode layer 88, p gate layer 87, n gate layer 86, p anode layer 85, tunnel junction layer 84, n cathode (DBR) layer 83, light-emitting layer 82, and p anode (DBR) layer 81 are etched in the above order and separated into islands such as the islands 301 and 302. The etching may be performed by wet etching using a sulfuric acid etchant (with a 1:10:300 ratio of sulfuric acid, hydrogen peroxide, and water by weight) or by anisotropic dry etching (RIE) using boron chloride, for example. The etching in the semiconductor stack isolation process is also referred to as mesa etching or post-etching.

Next, in the current blocking section formation process, the current narrowing layer 83a, which was exposed from the sides by the semiconductor stack isolation process, is oxidized from the sides to form the current blocking section β that blocks a current. The remaining, non-oxidized portion is the current passing section α. The oxidation of the current narrowing layer 83a is performed by oxidizing the Al in the current narrowing layer 83a, which is AlGaAs or the like, by steam oxidation at 300°C to 400°C, for example. The oxidation proceeds from the exposed sides, forming the current blocking section β with an oxide of Al, namely Al₂O₃, around the islands such as the islands 301 and 302. The non-oxidized portion of the current narrowing layer 83a is the current passing section α.

In a p gate layer exposing etching process, the n cathode layer 88 to expose the p gate layer 87. The etching may be performed by wet etching using a sulfuric acid etchant (with a 1:10:300 ratio of sulfuric acid, hydrogen peroxide, and water by weight) or by anisotropic dry etching using boron chloride, for example.

In a p ohmic electrode formation process, the p ohmic electrodes 331, 332, and the like are formed on the p gate layer 87. The p ohmic electrodes (p ohmic electrodes 331, 332, and the like) are, for example, Zn-containing Au (AuZn), which easily makes ohmic contact with a p-type semiconductor layer such as the p gate layer 87. Additionally, the p ohmic electrodes (p ohmic electrodes 331, 332, and the like) are formed by a process such as lift-off, for example.

In the protective layer formation process, the protective layer 90 is formed to cover the surfaces of the islands 301, 302, and the like with an insulating material such as SiO₂, SiON, or SiN, for example. In addition, through-holes (openings) are made in the protective layer 90 on top of the n ohmic electrodes (n ohmic electrodes 321, 323, 324, and the like) and the p ohmic electrodes (p ohmic electrodes 331, 332, and the like).

In the wiring and other formation process, the wiring (power supply line 71, first transfer signal line 72, second transfer signal line 73, lighting signal line 75, and the like) connecting the n ohmic electrodes (n ohmic electrodes 321, 323, 324, and the like) and the p ohmic electrodes (p ohmic electrodes 331, 332, and the like), the back electrode 91, and the light-blocking layer 95 are formed via the through-holes made in the protective layer 90. The wiring, the back electrode 91, and the light-blocking layer 95 are Au, Al, or the like.

Through the above processes, the light-emitting chip 10 of the exemplary embodiment is obtained. Note that in the light-emitting chip 10 of the exemplary embodiment, the VCSEL and the setting thyristor S are layered. With this arrangement, the light-emitting chip 10 is self-scanning, in which the VCSELs are lighted individually by the transfer thyristor T and the setting thyristor S. Accordingly, fewer terminals are provided in the light-emitting chip 10, resulting in a compact light-emitting chip 10 and light source device 1.

The foregoing describes an exemplary embodiment of the present disclosure, but the technical scope of the present disclosure is not limited to the exemplary embodiment above. For example, in the light source device 1 of the exemplary embodiment described above, an example is described in which the controller 110 and the transfer unit 12 of the light-emitting chip 10 act as a driving unit that individually drives and causes the setting thyristors S to switch to the ON state, but the setting thyristors S may also be driven individually by sending signals to the setting thyristors S directly from the controller 110.

Otherwise, various modifications and substitutions that do not depart from the scope of the technical ideas of the present disclosure are also included in the present disclosure.

The foregoing description of the exemplary embodiments of the present disclosure has been provided for the purposes of illustration and description. It is not intended to be exhaustive or to limit the disclosure to the precise forms disclosed. Obviously, many modifications and variations will be apparent to practitioners skilled in the art. The embodiments were chosen and described in order to best explain the principles of the disclosure and its practical applications, thereby enabling others skilled in the art to understand the disclosure for various embodiments and with the various modifications as are suited to the particular use contemplated. It is intended that the scope of the disclosure be defined by the following claims and their equivalents.

### (Appendix)

(((1))) A light-emitting component comprising:
   a substrate;
   a plurality of light-emitting elements provided on the substrate, each having a light-emitting area; and
   a plurality of thyristors which are provided on each of the light-emitting elements, which include gate layers, and which cause light to be emitted, or increase an amount of light emitted, from the light-emitting areas of the light-emitting elements by being in an ON state,
   wherein:
   the substrate absorbs light emitted from the thyristors and emits light not absorbed by the gate layers.
(((2))) The light-emitting component according to (((1))), wherein:
   the light-emitting elements transmit light emitted from the thyristors. (((3)))
(((3))) The light-emitting component according to (((2))), wherein:
   the light-emitting elements have a semiconductor layer containing Al; and
   the gate layers of the thyristors contain Al and are formed from a semiconductor with a low Al content ratio compared to the semiconductor layer of the light-emitting elements.
(((4))) The light-emitting component according to (((3))), wherein:
   the semiconductor layer of the light-emitting elements is a multilayer reflective layer in which a first semiconductor layer formed from AlGaAs and a second semiconductor layer formed from AlGaAs with a high Al content ratio compared to the first semiconductor layer are layered alternately; and
   the gate layers of the thyristors are formed from AlGaAs with a low Al content ratio compared to the first semiconductor layer of the multilayer reflective layer.
(((5))) The light-emitting component according to (((2))), wherein:
   the light-emitting elements have a lower semiconductor layer layered on the substrate, a light-emitting layer layered on the lower semiconductor layer, and an upper semiconductor layer layered on the light-emitting layer, the upper semiconductor layer having a high transmittance of light emitted from the thyristors compared to the lower semiconductor layer.
(((6))) The light-emitting component according to any one of (((1))) to (((5))), wherein:
   the substrate emits, toward the light-emitting elements, light of a longer wavelength than the light emitted from the thyristors.
(((7))) The light-emitting component according to (((6))), wherein:
   the gate layers of the thyristors are formed from a semiconductor containing Al; and
   the substrate is formed from GaAs.
(((8))) A multilayer semiconductor substrate comprising:
   a substrate;
   a first semiconductor stack which is provided on the substrate and which is worked into a light-emitting element; and
   a second semiconductor stack which is provided on the first semiconductor stack, which includes gate layers, and which is worked into a plurality of thyristors, wherein:
      the substrate is formed from a semiconductor with a low band gap energy compared to the gate layers of the second semiconductor stack.
(((9))) A light-emitting device comprising:
   a substrate;
   a plurality of light-emitting elements provided on the substrate, each having a light-emitting area;
   a plurality of thyristors which are provided on each of the light-emitting elements, which include gate layers, and which cause light to be emitted, or increase an amount of light emitted, from the light-emitting areas of the light-emitting elements by being in an ON state; and
   a driving unit that individually drives and causes the plurality of thyristors to switch to an ON state,
   wherein:
   the substrate absorbs light emitted from the thyristors and emits light not absorbed by the gate layers.
(((10))) A measurement apparatus comprising:
   a substrate;
   a plurality of light-emitting elements provided on the substrate, each having a light-emitting area;
   a plurality of thyristors which are provided on each of the light-emitting elements, which include gate layers, and which cause light to be emitted, or increase an amount of light emitted, from the light-emitting areas of the light-emitting elements by being in an ON state;
   a driving unit that individually drives the plurality of thyristors and causes each of the light-emitting areas to emit light at a predetermined timing; and
   an acquisition unit that acquires information related to an object on a basis of reflected light obtained due to the object reflecting the light from each of the light-emitting areas,
   wherein:
   the substrate absorbs light emitted from the thyristors and emits light not absorbed by the gate layers.
(((11))) The light-emitting component according to (((2))), wherein:
   the gate layers of the thyristors are formed from a semiconductor with a low band gap energy compared to a semiconductor layer of the light-emitting elements.
(((12))) The light-emitting component according to (((11))), wherein:
   the semiconductor layer of the light-emitting elements is a multilayer reflective layer in which a first semiconductor layer and a second semiconductor layer with a high band gap energy compared to the first semiconductor layer are layered alternately; and
   the gate layers of the thyristors are formed from a material with a low band gap energy compared to the first semiconductor layer of the multilayer reflective layer.
(((13))) The light-emitting component according to (((2))), wherein:
   the light-emitting elements have a semiconductor layer containing Al; and
   the gate layers of the thyristors are formed from a semiconductor not containing Al.

According to the light-emitting component according to (((1))), it is possible to keep a thyristor from being switched to the ON state by light emitted from another thyristor compared to a case in which a substrate provided with light-emitting elements and multiple thyristors does not absorb light emitted from the thyristors.

According to the light-emitting component according to (((2))), it is possible to suppress a temperature rise in a light-emitting element compared to a case in which the light-emitting element does not transmit light emitted from a thyristor.

According to the light-emitting component according to (((3))), light emitted from a thyristor is absorbed less easily by a light-emitting element compared to a case in which the gate layers of the thyristor have a higher Al content ratio than the semiconductor layer of the light-emitting element.

According to the light-emitting component according to (((4))), light emitted from a thyristor is absorbed less easily by a light-emitting element compared to a case in which the gate layers of the thyristor are formed from AlGaAs having a higher Al content ratio than a first semiconductor layer.

According to the light-emitting component according to (((5))), a degradation in the characteristics of a light-emitting element due to a temperature rise is suppressed compared to a case in which an upper semiconductor layer has a low transmittance of light emitted from a thyristor compared to a lower semiconductor layer.

According to the light-emitting component according to (((6))), light emitted from a substrate is absorbed less easily by a thyristor compared to a case in which the substrate emits light on the same wavelength as light emitted from the thyristor.

According to the light-emitting component according to (((7))), light emitted from a substrate is absorbed less easily by a thyristor compared to case in which the substrate contains Al.

According to the multilayer semiconductor substrate according to (((8))), it is possible to keep a thyristor from being switched to the ON state by light emitted from another thyristor compared to a case in which a substrate provided with light-emitting elements and multiple thyristors does not absorb light emitted from the thyristors.

According to the light-emitting device according to (((9))), it is possible to keep a thyristor from being switched to the ON state by light emitted from another thyristor compared to a case in which a substrate provided with light-emitting elements and multiple thyristors does not absorb light emitted from the thyristors.

According to the measurement apparatus according to (((10))), it is possible to keep a thyristor from being switched to the ON state by light emitted from another thyristor compared to a case in which a substrate provided with light-emitting elements and multiple thyristors does not absorb light emitted from the thyristors.

According to the light-emitting component according to (((11))), light emitted from a thyristor is absorbed less easily by a light-emitting element.

According to the light-emitting component according to (((12))), light emitted from a thyristor is absorbed less easily by a light-emitting element.

According to the light-emitting component according to (((13))), light emitted from a thyristor is absorbed less easily by a light-emitting element.

## Claims

1. A light-emitting component comprising:
a substrate;
a plurality of light-emitting elements provided on the substrate, each having a light-emitting area; and
a plurality of thyristors which are provided on each of the light-emitting elements, which include gate layers, and which cause light to be emitted, or increase an amount of light emitted, from the light-emitting areas of the light-emitting elements by being in an ON state,
wherein:
the substrate absorbs light emitted from the thyristors and emits light not absorbed by the gate layers.

2. The light-emitting component according to claim 1, wherein the light-emitting elements transmit light emitted from the thyristors.

3. The light-emitting component according to claim 2, wherein:
the light-emitting elements have a semiconductor layer containing Al; and
the gate layers of the thyristors contain Al and are formed from a semiconductor with a low Al content ratio compared to the semiconductor layer of the light-emitting elements.

4. The light-emitting component according to claim 3, wherein:
the semiconductor layer of the light-emitting elements is a multilayer reflective layer in which a first semiconductor layer formed from AlGaAs and a second semiconductor layer formed from AlGaAs with a high Al content ratio compared to the first semiconductor layer are layered alternately; and
the gate layers of the thyristors are formed from AlGaAs with a low Al content ratio compared to the first semiconductor layer of the multilayer reflective layer.

5. The light-emitting component according to claim 2, wherein the light-emitting elements have a lower semiconductor layer layered on the substrate, a light-emitting layer layered on the lower semiconductor layer, and an upper semiconductor layer layered on the light-emitting layer, the upper semiconductor layer having a high transmittance of light emitted from the thyristors compared to the lower semiconductor layer.

6. The light-emitting component according to any one of claims 1 to 5, wherein the substrate emits, toward the light-emitting elements, light of a longer wavelength than the light emitted from the thyristors.

7. The light-emitting component according to claim 6, wherein:
the gate layers of the thyristors are formed from a semiconductor containing Al; and
the substrate is formed from GaAs.

8. A multilayer semiconductor substrate comprising:
a substrate;
a first semiconductor stack which is provided on the substrate and which is worked into a light-emitting element; and
a second semiconductor stack which is provided on the first semiconductor stack, which includes gate layers, and which is worked into a plurality of thyristors, wherein
the substrate is formed from a semiconductor with a low band gap energy compared to the gate layers of the second semiconductor stack.

9. A light-emitting device comprising:
a substrate;
a plurality of light-emitting elements provided on the substrate, each having a light-emitting area;
a plurality of thyristors which are provided on each of the light-emitting elements, which include gate layers, and which cause light to be emitted, or increase an amount of light emitted, from the light-emitting areas of the light-emitting elements by being in an ON state; and
a driving unit that individually drives and causes the plurality of thyristors to switch to an ON state,
wherein:
the substrate absorbs light emitted from the thyristors and emits light not absorbed by the gate layers.

10. A measurement apparatus comprising:
a substrate;
a plurality of light-emitting elements provided on the substrate, each having a light-emitting area;
a plurality of thyristors which are provided on each of the light-emitting elements, which include gate layers, and which cause light to be emitted, or increase an amount of light emitted, from the light-emitting areas of the light-emitting elements by being in an ON state;
a driving unit that individually drives the plurality of thyristors and causes each of the light-emitting areas to emit light at a predetermined timing; and
an acquisition unit that acquires information related to an object on a basis of reflected light obtained due to the object reflecting the light from each of the light-emitting areas,
wherein:
the substrate absorbs light emitted from the thyristors and emits light not absorbed by the gate layers.

11. The light-emitting component according to claim 2, wherein the gate layers of the thyristors are formed from a semiconductor with a low band gap energy compared to a semiconductor layer of the light-emitting elements.

12. The light-emitting component according to claim 11, wherein:
the semiconductor layer of the light-emitting elements is a multilayer reflective layer in which a first semiconductor layer and a second semiconductor layer with a high band gap energy compared to the first semiconductor layer are layered alternately, and
the gate layers of the thyristors are formed from a material with a low band gap energy compared to the first semiconductor layer of the multilayer reflective layer.

13. The light-emitting component according to claim 2, wherein:
the light-emitting elements have a semiconductor layer containing Al; and
the gate layers of the thyristors are formed from a semiconductor not containing Al.
